# EUROPEAN PATENT APPLICATION

(11) **EP 4 571 818 A1**
(43) Date of publication of application: **18.06.2025**
(21) Application number: 23865373.7
(22) Date of filing: 06.09.2023
(51) Int. Cl.: H01L 21/304, C11D 7/24, C11D 7/26, C11D 7/32, C11D 7/50

(54) **METHOD FOR CLEANING SEMICONDUCTOR SUBSTRATE, METHOD FOR PRODUCING PROCESSED SEMICONDUCTOR SUBSTRATE, AND PEELING AND DISSOLVING COMPOSITION**

(30) Priority: 13.09.2022 JP 2022145038
(71) Applicant: Nissan Chemical Corporation, Tokyo 103-6119 (JP)
(72) Inventor: YAGYU, Masafumi, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/032458
(87) International publication number: WO 2024/058018

(57) **Abstract**

The present invention provides: a method for cleaning a semiconductor substrate, by which it is possible to more cleanly remove (clean) an adhesive layer formed using, for example, a siloxane-based adhesive, from the semiconductor substrate having the adhesive layer on a surface of the semiconductor substrate in a shorter time by a simple operation; a method for producing a processed semiconductor substrate including such a cleaning method; and a composition which is used in such a cleaning method.

The present invention provides a method for cleaning a semiconductor substrate, the method including a step of releasing and dissolving an adhesive layer formed on a semiconductor substrate using a releasing and dissolving composition in which the releasing and dissolving composition contains: a component [I]: a quaternary ammonium salt; a component [II]: an amide-based solvent; a component [III]: a solvent represented by any one of the following Formulae (L0) to (L4); and a component [IV]: a solvent represented by Formula (T) or (G) below.

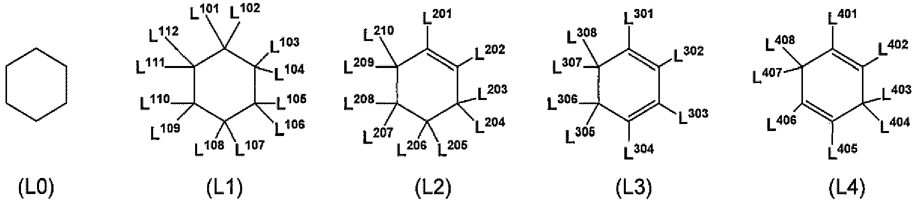

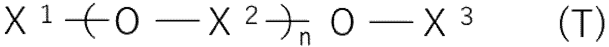

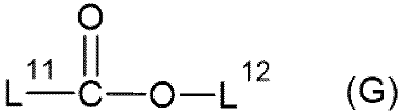

## Description

### Technical Field

The present invention relates to a method for cleaning a semiconductor substrate, a method for producing a processed semiconductor substrate, and a releasing and dissolving composition.

### Background Art

In respect of a semiconductor wafer that has been integrated in a two-dimensional planar direction in the related art, there is a need for a semiconductor integration technique that integrates (laminates) planes in a three-dimensional direction for the purpose of further integration. This three-dimensional lamination is a technique of laminating layers into a multilayer while connecting the layers by a through-silicon via (TSV). At the time of multilayer integration, each of wafers to be integrated is thinned by polishing on a side opposite to the formed circuit surface (i.e. a back surface), and the thinned semiconductor wafers are laminated.

A pre-thinned semiconductor wafer (also referred to herein simply as a wafer) is adhered to a support for polishing in a polishing device. The adhesion at that time must be easily released after polishing, and thus the adhesion is referred to as temporary adhesion. This temporary adhesion must be easily removed from the support, and when a large force is applied to the removal, the thinned semiconductor wafer may be cut or deformed, and is easily removed such that such a situation does not occur. However, at the time of polishing the back surface of the semiconductor wafer, it is not preferable for the semiconductor wafer to become detached or displaced due to polishing stress. Therefore, the performance required for temporary adhesion is to withstand the stress at the time of polishing and to be easily removed after polishing. For example, there is a demand for performance having a high stress (strong adhesive force) in a direction intersecting the planar direction at the time of polishing and a low stress (weak adhesive force) in the longitudinal direction at the time of removal. In addition, the temperature may become a high temperature of 150°C or higher in a processing step, and further, heat resistance is also required.

Under such circumstances, in the semiconductor field, a polysiloxane-based adhesive that can have these performances is mainly used as a temporary adhesive. In polysiloxane-based adhesion using the polysiloxane-based adhesive, an adhesive residue often remains on a surface of a substrate after a thinned substrate is released, but in order to avoid defects in subsequent steps, a cleaning agent composition for removing the residue and cleaning a surface of a semiconductor substrate has been developed (for example, see Patent Literatures 1 and 2). Patent Literature 1 discloses a siloxane resin removing agent containing a polar aprotic solvent and a quaternary ammonium hydroxide, and Patent Literature 2 discloses a curable resin removing agent containing an alkyl-ammonium fluoride. However, in the recent semiconductor field, there is always a demand for a novel cleaning agent composition, and there is always a demand for an effective cleaning agent composition and a cleaning method.

### Citation List

### Patent Literature

Patent Literature 1: WO 2014/092022 A
Patent Literature 2: US 6818608

### Summary of Invention

### Technical Problem

The cleaning agent compositions described in Patent Literatures 1 and 2 are intended to remove the adhesive residue from the surface of the substrate by dissolving the adhesive residue on the surface of the substrate, but it has been found that it takes a long time to remove the adhesive residue from the surface of the substrate by dissolution as described above.

Incidentally, as a result of examining the cleaning agent composition, the present inventors have found that when a composition containing a specific component is used, the adhesive layer can be swollen and the adhesive layer can be released from the substrate. When this composition containing a specific component is used, the adhesive layer can be removed from the substrate in a short time.

However, there is room for improvement from the viewpoint of more cleanly removing the adhesive residue from the surface of the substrate in a shorter time by a simple operation, and a novel cleaning method and a composition used for the cleaning method have been developed in search of a more effective cleaning method.

The present invention has been made in view of the above circumstances, and an object of the present invention is to provide a method for cleaning a semiconductor substrate, by which it is possible to more cleanly remove (clean) an adhesive layer formed using, for example, a siloxane-based adhesive, from the semiconductor substrate having the adhesive layer on a surface of the semiconductor substrate in a shorter time by a simple operation; a method for producing a processed semiconductor substrate including such a cleaning method; and a composition which is used in such a cleaning method.

### Solution to Problem

As a result of intensive studies to solve the above problems, the present inventors have found that the above problems can be solved by cleaning an adhesive layer on a semiconductor substrate, particularly, an adhesive layer which is a cured film prepared from a siloxane-based adhesive containing a polyorganosiloxane component (A') cured by a hydrosilylation reaction using a composition containing a specific component, to simultaneously perform swelling, releasing and dissolving operations of the adhesive layer by one cleaning operation so as to eliminate the adhesive layer from the semiconductor substrate, thereby completing the present invention.

That is, the present invention encompasses the following aspects.
[1] A method for cleaning a semiconductor substrate, the method including a step of releasing and dissolving an adhesive layer formed on a semiconductor substrate using a releasing and dissolving composition, wherein the releasing and dissolving composition contains: a component [I]: a quaternary ammonium salt; a component [II]: an amide-based solvent; a component [III]: a solvent represented by any one of the following Formulae (L0) to (L4); and a component [IV]: a solvent represented by Formula (T) or (G) below: 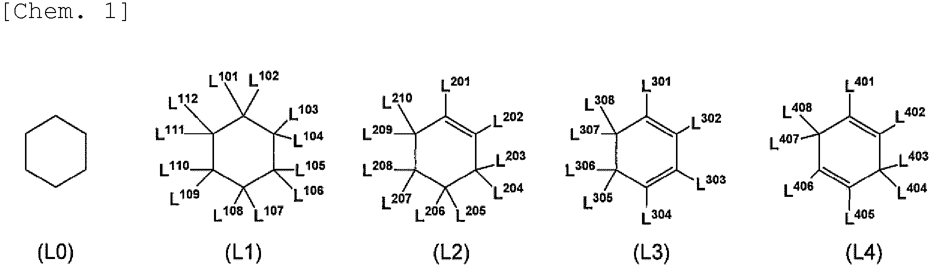
   where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 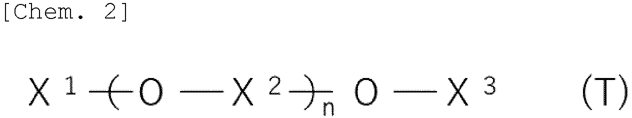
   where X¹ and X³ each independently represent an alkyl group or an acyl group (X⁴-C(=O)-), X² represents an alkylene group, n represents 2 or 3, and X⁴ represents an alkyl group 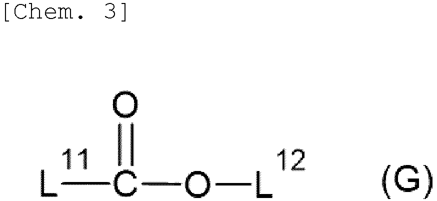
   where L¹¹ and L¹² each independently represent an alkyl group having 1 to 6 carbon atoms, and a total number of carbon atoms of the alkyl group in L¹¹ and the alkyl group in L¹² is 7 or less.
[2] The method for cleaning a semiconductor substrate according to [1], wherein the quaternary ammonium salt is a halogen-containing quaternary ammonium salt.
[3] The method for cleaning a semiconductor substrate according to [1] or [2], wherein the amide-based solvent is an acid amide derivative represented by the following Formula (Z) or a compound represented by the following Formula (Y): 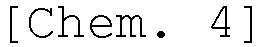 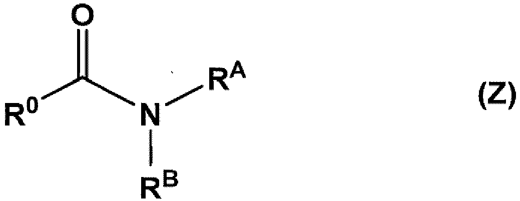 where R⁰ represents an ethyl group, a propyl group, or an isopropyl group, and R^{A} and R^{B} each independently represent an alkyl group having 1 to 4 carbon atoms 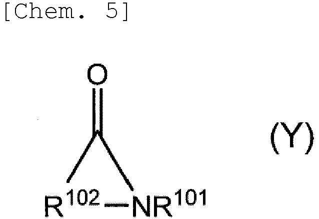 where R¹⁰¹ represents a hydrogen atom or an alkyl group having 1 to 6 carbon atoms, and R¹⁰² represents an alkylene group having 1 to 6 carbon atoms or a group represented by the following Formula (Y1) 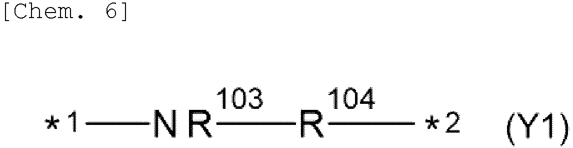 where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).
[4] The method for cleaning a semiconductor substrate according to any one of [1] to [3], wherein the alkyl group having 1 to 5 carbon atoms is a methyl group, an ethyl group, an n-propyl group, or an isopropyl group,
   the alkenyl group having 2 to 5 carbon atoms is an ethenyl group, a 1-methylethenyl group, or a 2-methylethenyl group, and
   the alkynyl group having 2 to 5 carbon atoms is an ethynyl group or a 2-methylethynyl group.
[5] The method for cleaning a semiconductor substrate according to [4], wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
   one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.
[6] The method for cleaning a semiconductor substrate according to any one of [1] to [5], wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[7] The method for cleaning a semiconductor substrate according to [6], wherein the adhesive component (S) contains a siloxane-based adhesive.
[8] The method for cleaning a semiconductor substrate according to [7], wherein the siloxane-based adhesive includes a polyorganosiloxane component (A') which is cured by a hydrosilylation reaction.
[9] The method for cleaning a semiconductor substrate according to any one of [1] to [8], wherein the step of releasing and dissolving an adhesive layer includes a step of eliminating the released adhesive layer.
[10] A method for producing a processed semiconductor substrate, the method including:
   a first step of producing a laminate including a semiconductor substrate, a support substrate, and an adhesive layer formed from an adhesive composition;
   a second step of processing the semiconductor substrate of the produced laminate;
   a third step of separating the semiconductor substrate and the adhesive layer from the support substrate; and
   a fourth step of releasing and dissolving the adhesive layer using a releasing and dissolving composition to remove the adhesive layer on the semiconductor substrate; wherein the releasing and dissolving composition contains:
      a component [I]: a quaternary ammonium salt;
      a component [II]: an amide-based solvent;
      a component [III]: a solvent represented by any one of the following Formulae (L0) to (L4); and
      a component [IV]: a solvent represented by Formula (T) or (G) below: 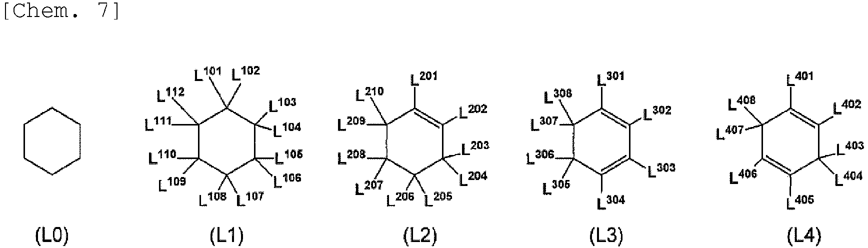
      where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 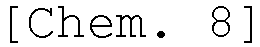 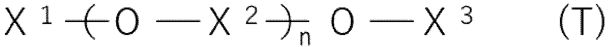
      where X¹ and X³ each independently represent an alkyl group or an acyl group (X⁴-C(=O)-), X² represents an alkylene group, n represents 2 or 3, and X⁴ represents an alkyl group 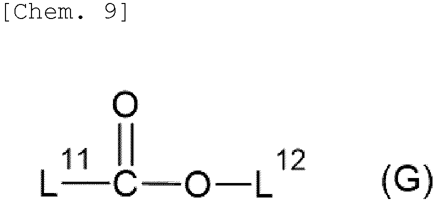
      where L¹¹ and L¹² each independently represent an alkyl group having 1 to 6 carbon atoms, and a total number of carbon atoms of the alkyl group in L¹¹ and the alkyl group in L¹² is 7 or less.
[11] The method for producing a processed semiconductor substrate according to [10], wherein the quaternary ammonium salt is a halogen-containing quaternary ammonium salt.
[12] The method for producing a processed semiconductor substrate according to [10] or [11], wherein the amide-based solvent is an acid amide derivative represented by the following Formula (Z) or a compound represented by the following Formula (Y): 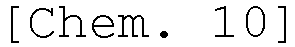 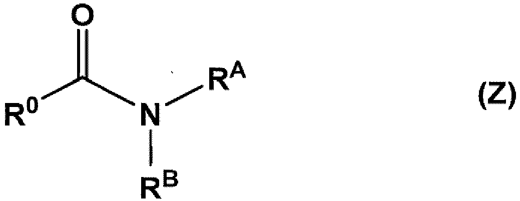 where R⁰ represents an ethyl group, a propyl group, or an isopropyl group, and R^{A} and R^{B} each independently represent an alkyl group having 1 to 4 carbon atoms 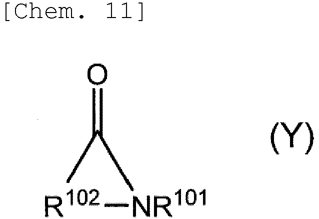 where R¹⁰¹ represents a hydrogen atom or an alkyl group having 1 to 6 carbon atoms, and R¹⁰² represents an alkylene group having 1 to 6 carbon atoms or a group represented by the following Formula (Y1) 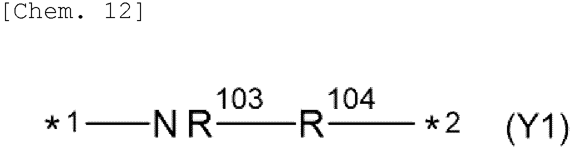 where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).
[13] The method for producing a semiconductor substrate according to any one of [10] to [12], wherein the alkyl group having 1 to 5 carbon atoms is a methyl group, an ethyl group, an n-propyl group, or an isopropyl group,
   the alkenyl group having 2 to 5 carbon atoms is an ethenyl group, a 1-methylethenyl group, or a **2-**methylethenyl group, and
   the alkynyl group having 2 to 5 carbon atoms is an ethynyl group or a 2-methylethynyl group.
[14] The method for producing a semiconductor substrate according to [13], wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
   one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.
[15] The method for producing a processed semiconductor substrate according to any one of [10] to [14], wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[16] The method for producing a processed semiconductor substrate according to [15], wherein the adhesive component (S) contains a siloxane-based adhesive.
[17] The method for producing a processed semiconductor substrate according to [16], wherein the siloxane-based adhesive contains a polyorganosiloxane component (A') which is cured by a hydrosilylation reaction.
[18] The method for producing a processed semiconductor substrate according to any one of [10] to [17], wherein the fourth step of releasing and dissolving the adhesive layer to remove the adhesive layer includes a step of eliminating the released adhesive layer.
[19] A releasing and dissolving composition used for releasing and dissolving an adhesive layer on a semiconductor substrate when the semiconductor substrate is cleaned to remove the adhesive layer, the releasing and dissolving composition comprising:
   a component [I]: a quaternary ammonium salt;
   a component [II]: an amide-based solvent;
   a component [III]: a solvent represented by any one of the following Formulae (L0) to (L4); and
   a component [IV]: a solvent represented by Formula (T) or (G) below;
   wherein in the releasing and dissolving composition, a content of the component [III] is 20 mass% or more and a content of the component [IV] is 20 mass% or more, relative to 100 mass% of an aprotic solvent: 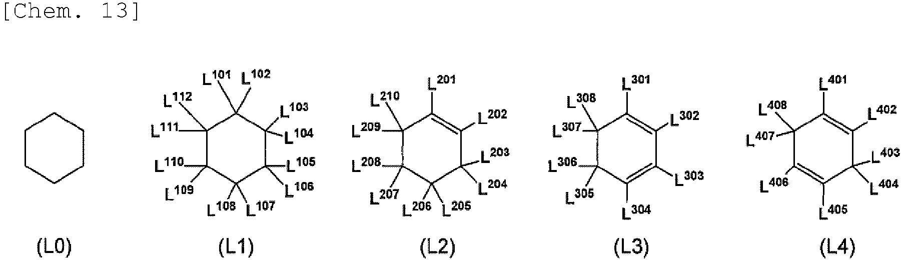
   where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 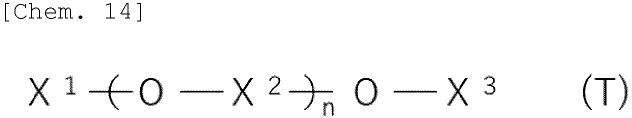
   where X¹ and X³ each independently represent an alkyl group or an acyl group (X⁴-C(=O)-), X² represents an alkylene group, n represents 2 or 3, and X⁴ represents an alkyl group 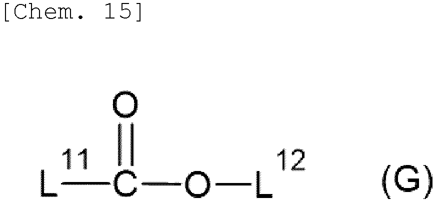
   where L¹¹ and L¹² each independently represent an alkyl group having 1 to 6 carbon atoms, and a total number of carbon atoms of the alkyl group in L¹¹ and the alkyl group in L¹² is 7 or less.
[20] The releasing and dissolving composition according to [19], wherein the quaternary ammonium salt is a halogen-containing quaternary ammonium salt.
[21] The releasing and dissolving composition according to [19] or [20], wherein the amide-based solvent is an acid amide derivative represented by the following Formula (Z) or a compound represented by the following Formula (Y): 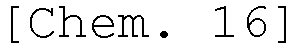 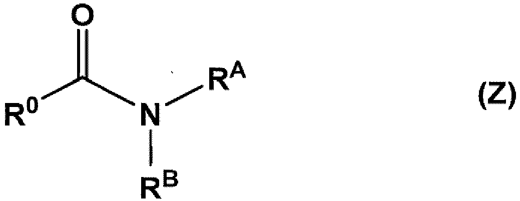 where R⁰ represents an ethyl group, a propyl group, or an isopropyl group, and R^{A} and R^{B} each independently represent an alkyl group having 1 to 4 carbon atoms 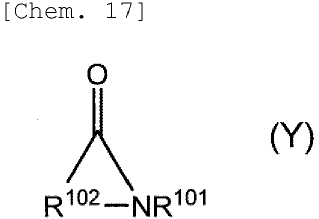 where R¹⁰¹ represents a hydrogen atom or an alkyl group having 1 to 6 carbon atoms, and R¹⁰² represents an alkylene group having 1 to 6 carbon atoms or a group represented by the following Formula (Y1) where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).
[22] The releasing and dissolving composition according to any one of [19] to [21], wherein the alkyl group having 1 to 5 carbon atoms is a methyl group, an ethyl group, an **n-**propyl group, or an isopropyl group,
   the alkenyl group having 2 to 5 carbon atoms is an ethenyl group, a 1-methylethenyl group, or a **2-**methylethenyl group, and
   the alkynyl group having 2 to 5 carbon atoms is an ethynyl group or a 2-methylethynyl group.
[23] The releasing and dissolving composition according to [22] wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
   one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
   one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.
[24] The releasing and dissolving composition according to any one of [19] to [23], wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[25] The processed releasing and dissolving composition according to [24], wherein the adhesive component (S) contains a siloxane-based adhesive.
[26] The releasing and dissolving composition according to [25], wherein the siloxane-based adhesive contains a polyorganosiloxane component (A') which is cured by a hydrosilylation reaction.

### Advantageous Effects of Invention

According to the present invention, it is possible to provide a method for cleaning a semiconductor substrate, by which it is possible to more cleanly remove (clean) an adhesive layer formed using, for example, a siloxane adhesive, from the semiconductor substrate having the adhesive layer on a surface of the semiconductor substrate in a shorter time by a simple operation; a method for producing a processed semiconductor substrate including such a cleaning method; and a composition which is used in such a cleaning method.

### Description of Embodiments

Hereinafter, the present invention will be described in detail. Note that the descriptions of the constituent elements described below are examples for describing the present invention, and the present invention is not limited to these contents.

### (Method for Cleaning Semiconductor Substrate)

The method for cleaning a semiconductor substrate of the present invention includes a step of releasing and dissolving an adhesive layer on the semiconductor substrate using a releasing and dissolving composition.

The releasing and dissolving composition contains:
a component [I]: a quaternary ammonium salt;
a component [II]: an amide-based solvent;
a component [III]: a solvent represented by any one of the following Formulae (L0) to (L4); and
a component [IV]: a solvent represented by Formula (T) or (G) below: 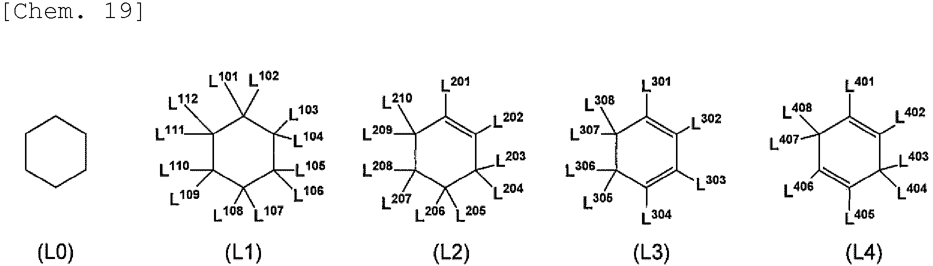
where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 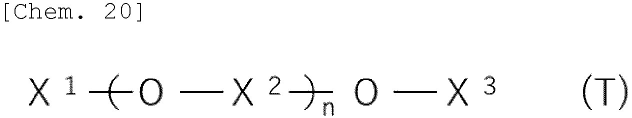
where X¹ and X³ each independently represent an alkyl group or an acyl group (X⁴-C(=O)-), X² represents an alkylene group, n represents 2 or 3, and X⁴ represents an alkyl group 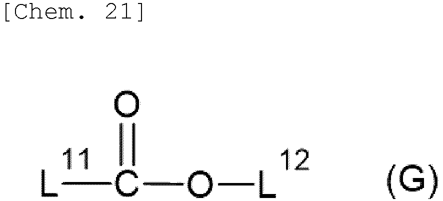
where L¹¹ and L¹² each independently represent an alkyl group having 1 to 6 carbon atoms, and a total number of carbon atoms of the alkyl group in L¹¹ and the alkyl group in L¹² is 7 or less.

### <Semiconductor substrate>

The main material forming the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 µm.

The diameter of the disk-shaped semiconductor substrate may be appropriately determined according to the purpose of use of the semiconductor substrate and the like, and is not particularly limited, and is, for example, 100 to 1,000 mm.

The semiconductor substrate is, for example, a wafer, and specific examples thereof include, but are not limited to, a silicon wafer having a diameter of about 300 mm and a thickness of about 770 µm.

### <Adhesive Layer>

The adhesive layer on the semiconductor substrate is, for example, a film formed from an adhesive composition containing the adhesive component (S).

The adhesive component (S) is not particularly limited as long as it is used for this type of application, and examples thereof include siloxane-based adhesives, acrylic resin-based adhesives, epoxy resin-based adhesives, polyamide-based adhesives, polystyrene-based adhesives, polyimide adhesives, and phenolic resin-based adhesives.

Among them, the adhesive component (S) is preferably a siloxane-based adhesive, which exhibits suitable adhesive ability during processing of a wafer or the like, can be suitably released after processing, and is excellent in heat resistance.

### <<Adhesive Composition>>

In a preferred aspect, the adhesive composition to be used in the present invention contains a component (A) that is cured by hydrosilylation reaction as the adhesive component.

Further, in a preferred aspect, the adhesive composition to be used in the present invention contains a polyorganosiloxane.

The component (A) may be a component that is cured by hydrosilylation reaction, or may be a polyorganosiloxane component (A') that is cured by hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms is optionally substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') to be cured by the hydrosilylation reaction includes a polysiloxane (A1) containing one or more units selected from the group consisting of siloxane units (Q units) represented by SiO₂, siloxane units (M units) represented by R¹R²R³SiO_{1/2}, siloxane units (D units) represented by R⁴R⁵SiO_{2/2}, and siloxane units (T units) represented by R⁶SiO_{3/2}, and a platinum group metal-based catalyst (A2), and the polysiloxane (A1) includes a polyorganosiloxane (al') containing one or more units selected from the group consisting of siloxane units (Q' units) represented by SiO₂, siloxane units (M' units) represented by R¹'R²'R³'SiO_{1/2}, siloxane units (D' units) represented by R⁴'R⁵'SiO_{2/2}, and siloxane units (T' units) represented by R⁶'SiO_{3/2}, and containing at least one selected from the group consisting of M' units, D' units, and T' units, and a polyorganosiloxane (a2') containing one or more units selected from the group consisting of siloxane units (Q" units) represented by SiO₂, siloxane units (M" units) represented by R¹"R²"R³"SiO_{1/2}, siloxane units (D" units) represented by R⁴"R⁵"SiO_{2/2}, and siloxane units (T" units) represented by R⁶"SiO_{3/2}, and containing at least one selected from the group consisting of M" units, D" units, and T" units.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom, and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an optionally substituted alkyl group or a hydrogen atom, but at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be a linear, branched, or cyclic alkyl group, but is preferably a linear or branched alkyl group. The number of carbon atoms thereof is not particularly limited, and is ordinarily 1 to 40, preferably 30 or less, more preferably 20 or less, and still more preferably 10 or less.

Specific examples of the optionally substituted linear or branched alkyl group include a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1 methyl-n-propyl group, and a 1-ethyl-2 methyl-n-propyl group, but are not limited thereto, and the number of carbon atoms thereof is ordinarily 1 to 14, preferably 1 to 10, and more preferably 1 to 6. Among these groups, a methyl group is particularly preferred.

Specific examples of the optionally substituted cyclic alkyl group include a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, but are not limited thereto, and the number of carbon atoms thereof is ordinarily 3 to 14, preferably 4 to 10, and more preferably 5 to 6.

The alkenyl group may be a linear or branched alkenyl group, and the number of carbon atoms thereof is not particularly limited, and is ordinarily 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group. The number of carbon atoms thereof is ordinarily 2 to 14, preferably 2 to 10, and more preferably 1 to 6. Among these groups, an ethenyl group and a 2-propenyl group are particularly preferred.

Specific examples of the optionally substituted cyclic alkenyl group include, but are not limited to, cyclopentenyl and cyclohexenyl, and the number of carbon atoms thereof is ordinarily 4 to 14, preferably 5 to 10, and more preferably 5 to 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferred combinations of two or more selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, in a case where two or more kinds of polyorganosiloxanes contained in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferred, but are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms thereof, and a ratio of alkenyl groups in all substituents represented by R¹' to R⁶' is preferably 0.1 to 50.0 mol%, more preferably 0.5 to 30.0 mol%, and the remaining R¹' to R⁶' may be alkyl groups.

The polyorganosiloxane (a2') is composed of siloxane units in which alkyl groups and/or hydrogen atoms are bonded to silicon atoms thereof, and a ratio of hydrogen atoms in all substituents and substitutional atoms represented by R¹" to R⁶" is preferably 0.1 to 50.0 mol%, more preferably 10.0 to 40.0 mol%, and the remaining R¹" to R⁶" may be alkyl groups.

In a case where the component (A) contains (a1) and (a2), in a preferred aspect of the present invention, a molar ratio of the alkenyl group contained in the polyorganosiloxane (a1) and the hydrogen atom constituting the Si-H bond contained in the polyorganosiloxane (a2) is in a range of 1.0 : 0.5 to 1.0 : 0.66.

The weight-average molecular weight of the polysiloxane such as the polyorganosiloxane (a1) or the polyorganosiloxane (a2) is not particularly limited, and is ordinarily 500 to 1,000,000, and is preferably 5,000 to 50,000 from the viewpoint of realizing the effects of the present invention with good reproducibility.

In the present invention, the weight-average molecular weight, the number average molecular weight, and the dispersity of the polyorganosiloxanes can be measured, for example, using a GPC apparatus (EcoSEC, HLC-8320GPC; manufactured by Tosoh Corporation) and a GPC column (TSKgel SuperMultipore HZ-N and TSKgel SuperMultipore HZ-H; manufactured by Tosoh Corporation), at a column temperature of 40°C, using tetrahydrofuran as an eluent (elution solvent), at a flow amount (flow rate) of 0.35 mL/min, and using polystyrene (Shodex from Showa Denko K.K.) as a standard sample.

The viscosity of each of the polyorganosiloxane (a1) and the polyorganosiloxane (a2) is not particularly limited, and is ordinarily 10 to 1,000,000 (mPa·s), and is preferably 50 to 20000 (mPa·s) from the viewpoint of realizing the effects of the present invention with good reproducibility. The viscosity of each of the polyorganosiloxane (a1) and the polyorganosiloxane (a2) is a value measured at 25°C with an E-type rotational viscometer.

The polyorganosiloxane (a1) and the polyorganosiloxane (a2) react with each other by a hydrosilylation reaction to form a film. Therefore, the mechanism of curing is different from a mechanism, for example, through silanol groups, and thus, any siloxane does not need to contain a functional group that forms a silanol group by hydrolysis, such as a silanol group or an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum black, platinum(II) chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, and is ordinarily in a range of 1.0 to 50.0 ppm relative to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include an alkynyl alcohol (e.g. 1-ethynyl-1-cyclohexanol and 1,1-diphenyl-2-propion-1-ol).

The amount of the polymerization inhibitor is not particularly limited, and is ordinarily 1,000.0 ppm or more relative to the total amount of the polyorganosiloxane (a1) and the polyorganosiloxane (a2) from the viewpoint of achieving the effect, and is 10,000.0 ppm or less from the viewpoint of preventing excessive suppression of the hydrosilylation reaction.

The adhesive composition used in the present invention may contain a release agent component (B). The release agent component (B) is included in the adhesive composition used in the present invention, as a result of which the resulting adhesive layer can be suitably released with good reproducibility.

Typical examples of the release agent component (B) include a polyorganosiloxane. In a preferred aspect, specific examples thereof include, but are not limited to, an epoxy group-containing polyorganosiloxane, a methyl group-containing polyorganosiloxane, and a phenyl group-containing polyorganosiloxane.

In another preferred aspect, examples of the release agent component (B) include a polydimethylsiloxane, and the polydimethylsiloxane may be modified. Examples of the polydimethylsiloxane which may be modified include, but are not limited to, an epoxy group-containing polydimethylsiloxane, an unmodified polydimethylsiloxane, and a phenyl group-containing polydimethylsiloxane.

The weight-average molecular weight of the polyorganosiloxane as the release agent component (B) is not particularly limited, but is ordinarily 100,000 to 2,000,000, and is preferably 200,000 to 1,200,000, more preferably 300,000 to 900,000 from the viewpoint of realizing the effects of the present invention with good reproducibility. In addition, the dispersity is not particularly limited, but is ordinarily 1.0 to 10.0, and is preferably 1.5 to 5.0, and more preferably 2.0 to 3.0 from the viewpoint of realizing suitable releasing with good reproducibility. In addition, the weight-average molecular weight and the dispersity can be measured by the above-described method related to the polysiloxane.

The complex viscosity of the polyorganosiloxane as the release agent component (B) can be measured at 25°C using a rheometer (e.g. Rheometer MCR-302, manufactured by Anton Paar GmbH).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being condensed with other rings, or may be an epoxy group forming a condensed ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, epoxy group-containing polydimethylsiloxane.

The epoxy group-containing polyorganosiloxane contains the above-described siloxane unit (D¹⁰ unit), but may contain a Q unit, an M unit, and/or a T unit, in addition to the D¹⁰ unit.

In a preferred aspect of the present invention, specific examples of the epoxy group-containing polyorganosiloxane include a polyorganosiloxane containing only a D¹⁰ unit, a polyorganosiloxane containing a D¹⁰ unit and a Q unit, a polyorganosiloxane containing a D¹⁰ unit and an M unit, a polyorganosiloxane containing a D¹⁰ unit and a T unit, a polyorganosiloxane containing a D¹⁰ unit, a Q unit, and an M unit, a polyorganosiloxane containing a D¹⁰ unit, an M unit, and a T unit, and a polyorganosiloxane containing a D¹⁰ unit, a Q unit, an M unit, and a T unit.

The epoxy group-containing polyorganosiloxane is preferably an epoxy group-containing polydimethylsiloxane having an epoxy value of 0.1 to 5. In addition, the weight-average molecular weight thereof is not particularly limited, but is ordinarily 1,500 to 500,000, and is preferably 100,000 or less from the viewpoint of suppressing precipitation in the adhesive.

Specific examples of the epoxy group-containing polyorganosiloxane include, but are not limited to, an epoxy group-containing polyorganosiloxane represented by each of Formulae (E1) to (E3).

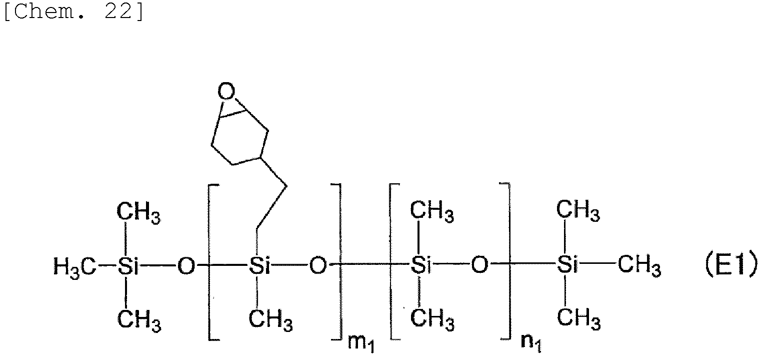

m₁ and n₁ represent the number of repeating units, and are positive integers.

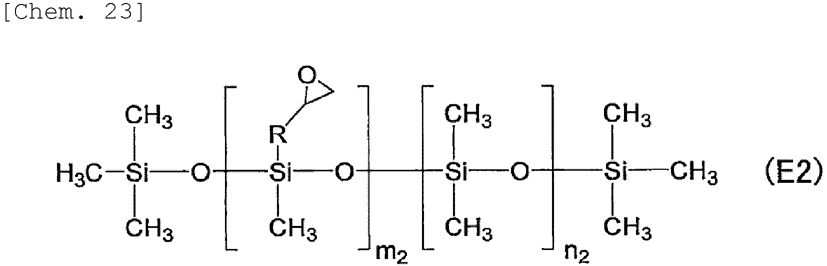

m₂ and n₂ represent the number of repeating units and are positive integers, and R is an alkylene group having 1 to 10 carbon atoms.

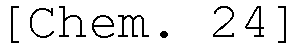

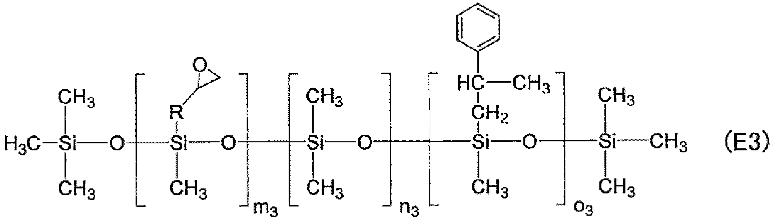

m₃, n₃, and o₃ represent the number of repeating units, and are positive integers, and R is an alkylene group having 1 to 10 carbon atoms.

Examples of the methyl group-containing polyorganosiloxane include a methyl group-containing polyorganosiloxane containing a siloxane unit (D²⁰⁰ unit) represented by R²¹⁰R²²⁰SiO_{2/2}, and preferably a methyl group-containing polyorganosiloxane containing a siloxane unit (D²⁰ unit) represented by R²¹R²¹SiO_{2/2}.

R²¹⁰ and R²²⁰ are groups bonded to a silicon atom, each independently represent an alkyl group, at least one of them is a methyl group, and specific examples of the alkyl group include the above-described examples.

R²¹ is a group bonded to a silicon atom and represents an alkyl group, and specific examples of the alkyl group include the above-described examples. Among them, R²¹ is preferably a methyl group.

In the present invention, preferred examples of the methyl group-containing polyorganosiloxane include, but are not limited to, polydimethylsiloxane.

The methyl group-containing polyorganosiloxane contains the siloxane unit (D²⁰⁰ unit or D²⁰ unit), but may contain a Q unit, an M units, and/or a T unit, in addition to the D²⁰⁰ unit and the D²⁰ unit.

In an aspect of the present invention, specific examples of the methyl group-containing polyorganosiloxane include a polyorganosiloxane containing only a D²⁰⁰ unit, a polyorganosiloxane containing a D²⁰⁰ unit and a Q unit, a polyorganosiloxane containing a D²⁰⁰ unit and an M unit, a polyorganosiloxane containing a D²⁰⁰ unit and a T unit, a polyorganosiloxane containing a D²⁰⁰ unit, a Q unit, and an M unit, a polyorganosiloxane containing a D²⁰⁰ unit, an M unit, and a T unit, and a polyorganosiloxanes containing a D²⁰⁰ unit, a Q unit, an M unit, and a T unit.

In a preferred aspect of the present invention, specific examples of the methyl group-containing polyorganosiloxane include a polyorganosiloxane composed only of a D²⁰ unit, a polyorganosiloxane containing a D²⁰ unit and a Q unit, a polyorganosiloxane containing a D²⁰ unit and an M unit, a polyorganosiloxane containing a D²⁰ unit and a T unit, a polyorganosiloxane containing a D²⁰ unit, a Q unit, and an M unit, a polyorganosiloxane containing a D²⁰ unit, an M unit, and a T unit, and a polyorganosiloxane containing a D²⁰ unit, a Q unit, an M unit, and a T unit.

Specific examples of the methyl group-containing polyorganosiloxane include, but are not limited to, a methyl group-containing polyorganosiloxane represented by Formula (M1).

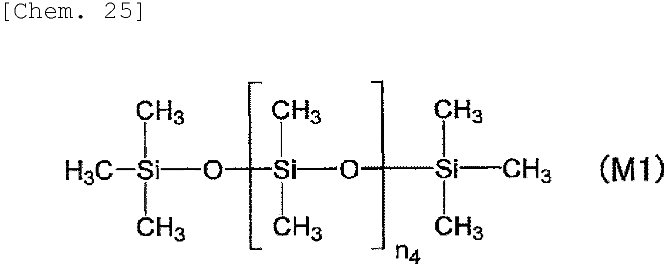

n₄ represents the number of repeating units, and is a positive integer.

Examples of the phenyl group-containing polyorganosiloxane include a phenyl group-containing polyorganosiloxane containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group include the above-described examples, and a methyl group is preferred.

The phenyl group-containing polyorganosiloxane contains the siloxane unit (D³⁰ unit) described above, but may contain a Q unit, an M unit, and/or a T unit, in addition to the D³⁰ unit.

In a preferred aspect of the present invention, specific examples of the phenyl group-containing polyorganosiloxane include a polyorganosiloxanes containing only of a D³⁰ unit, a polyorganosiloxane containing a D³⁰ unit and a Q unit, a polyorganosiloxane containing a D³⁰ unit and an M unit, a polyorganosiloxane containing a D³⁰ unit and a T unit, a polyorganosiloxanes containing a D³⁰ unit, a Q unit, and an M unit, a polyorganosiloxane containing a D³⁰ unit, an M unit, and a T unit, and a polyorganosiloxane containing a D³⁰ unit, a Q unit, an M unit, and a T unit.

Specific examples of the phenyl group-containing polyorganosiloxane include, but are not limited to, a phenyl group-containing polyorganosiloxane represented by Formulae (P1) or (P2).

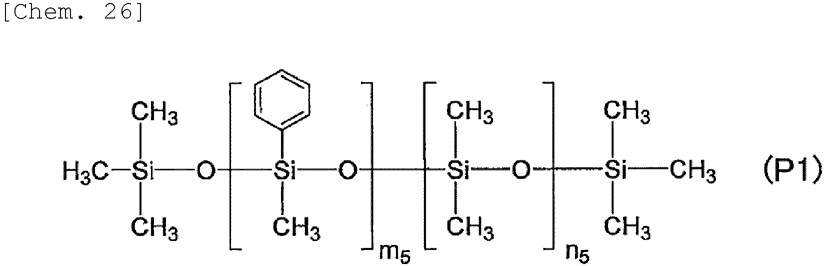

m₅ and n₅ represent the number of repeating units, and are positive integers.

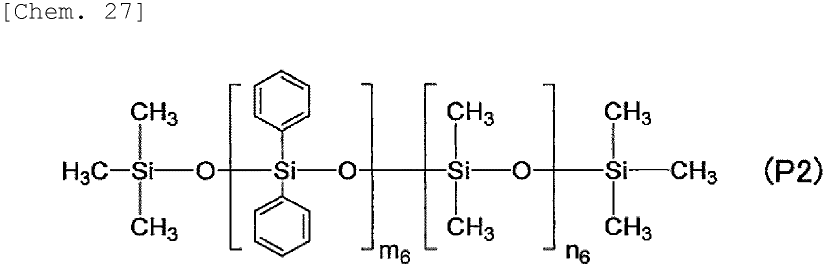

m₆ and n₆ represent the number of repeating units, and are positive integers.

The polyorganosiloxane as the release agent component (B) may be a commercially available product or a synthetic product.

Examples of the commercially available product of the polyorganosiloxane include Wacker Silicone Fluids AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane manufactured by Dow Corning Corporation (BY16-839); and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc., but are not limited thereto.

The adhesive composition used in the present invention contains a release agent component (B) together with the component (A) which is cured, and in a more preferred aspect, a polyorganosiloxane is contained as the release agent component (B).

An example of the adhesive composition used in the present invention can contain the component (A) which is cured and the release agent component (B) at any ratio. In consideration of a balance between adhesiveness and releasability, a ratio of the component (A) which is cured to the release agent component (B) is preferably 99.995 : 0.005 to 30 : 70, more preferably 99.9 : 0.1 to 75 : 25 in terms of mass ratio [(A) : (B)].

That is, in a case where the polyorganosiloxane component (A') which is cured by a hydrosilylation reaction is contained, a ratio of the component (A') to the release agent component (B) is preferably 99.995 : 0.005 to 30 : 70, more preferably 99.9 : 0.1 to 75 : 25 in terms of mass ratio [(A') : (B)].

The adhesive composition of the present invention may contain a solvent for the purpose of adjusting the viscosity and the like, and specific examples thereof include, but are not limited to, aliphatic hydrocarbon, aromatic hydrocarbon, and ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, or 5-nonanone. These solvents may be used singly or in combination of two or more kinds thereof.

In a case where the adhesive composition used in the present invention contains a solvent, the content thereof is appropriately set in consideration of a desired viscosity of a composition, a coating method to be adopted, a thickness of a thin film to be produced, and the like, and is in a range of about 10 to 90 mass% relative to the entire composition.

The viscosity of the adhesive composition used in the present invention is not particularly limited, but is ordinarily 500 to 20,000 mPa·s, and preferably 1,000 to 5,000 mPa·s at 25°C. The viscosity of the adhesive composition used in the present invention can be adjusted by changing the type of solvent to be used, the ratio thereof, the concentration of the film-forming components, and the like, in consideration of various factors such as the coating method to be used and the desired film thickness.

In the present invention, the term "film-forming components" means components other than a solvent contained in the composition.

As an example, the adhesive composition used in the present invention can be produced by mixing the component (A) with the release agent component (B) and a solvent when used.

The mixing order is not particularly limited. Examples of a method, by which an adhesive composition for releasing can be easily and reproducibly produced, include, but are not limited to, a method in which the component (A) and the release agent component (B) are dissolved in a solvent, and a method in which a part of the component (A) and the release agent component (B) is dissolved in a solvent, the rest is dissolved in the solvent, and the resulting solution is mixed. When the adhesive composition is prepared, the adhesive composition may be appropriately heated as long as the components are not decomposed or degenerated.

In the present invention, for the purpose of removing foreign matters, a solvent, a solution, or the like to be used may be filtered using a filter or the like during the production of the adhesive composition or after mixing all the components.

The thickness of the adhesive layer is not particularly limited, but is preferably 10 to 100 µm, more preferably 20 to 50 µm from the viewpoint of obtaining a good releasing effect with good reproducibility.

### <Releasing and Dissolving Composition>

The releasing and dissolving composition is a composition used for a method for cleaning a semiconductor substrate in order to eliminate an adhesive layer from the semiconductor substrate.

The releasing and dissolving composition contains a component for releasing the adhesive layer from the semiconductor substrate by swelling the adhesive layer, and a component for dissolving the adhesive layer.

Specifically, the releasing and dissolving composition contains:
a component [I]: a quaternary ammonium salt;
a component [II]: an amide-based solvent;
a component [III]: a solvent represented by any one of the following Formulae (L0) to (L4); and
a component [IV]: a solvent represented by Formula (T) or (G) below: 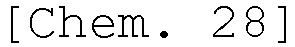 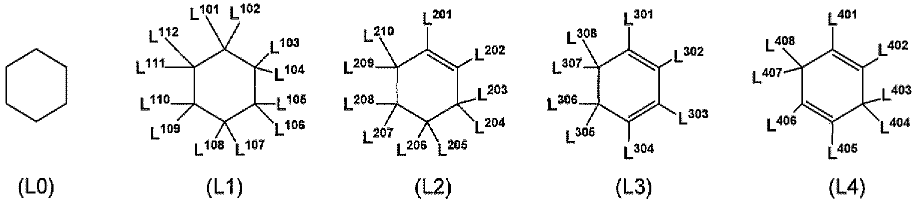
where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 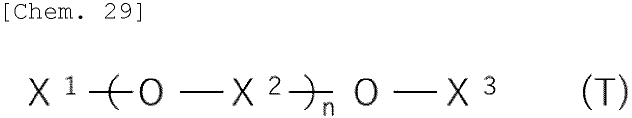
where X¹ and X³ each independently represent an alkyl group or an acyl group (X⁴-C(=O)-), X² represents an alkylene group, n represents 2 or 3, and X⁴ represents an alkyl group 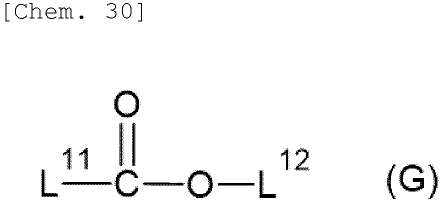
where L¹¹ and L¹² each independently represent an alkyl group having 1 to 6 carbon atoms, and a total number of carbon atoms of the alkyl group in L¹¹ and the alkyl group in L¹² is 7 or less.

### <<Component [I]: Quaternary Ammonium Salt>>

The quaternary ammonium salt is composed of a quaternary ammonium cation and an anion, and is not particularly limited as long as the quaternary ammonium salt is used for this type of application.

The quaternary ammonium salt is effective as a component for dissolving the adhesive layer.

Examples of such a quaternary ammonium cation typically include a tetra (hydrocarbon) ammonium cation. Meanwhile, examples of an anion paired therewith include, but are not limited to, a hydroxide ion (OH⁻); a halogen ion such as a fluorine ion (F⁻), a chlorine ion (Cl⁻), a bromine ion (Br⁻), or an iodine ion (I⁻)); a tetrafluoroborate ion (BF₄⁻); and a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, a halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride (also referred to as tetrabutylammonium fluoride). Among them, tetrabutylammonium fluoride is preferred.

A quaternary ammonium salt such as tetra(hydrocarbon)ammonium fluoride may be used as a hydrate. In addition, quaternary ammonium salts such as tetra(hydrocarbon)ammonium fluoride may be used singly or in combination of two or more kinds thereof.

The amount of the quaternary ammonium salt is not particularly limited as long as it dissolves in the solvent contained in the releasing and dissolving composition. The quaternary ammonium salt is preferably contained in a small amount because the problem of damage of a dicing tape in a cleaning step described below can be effectively prevented. Specifically, the amount of the quaternary ammonium salt is ordinarily 0.1 to 5 mass% relative to the releasing and dissolving composition, for example.

### <<Component [II]: Amide-Based Solvent>>

The amide-based solvent is effective as a component for preparing a releasing and dissolving composition which dissolves a quaternary ammonium salt well and has excellent uniformity.

The amide-based solvent is preferably an N-substituted amide compound having 4 or more carbon atoms and having no active hydrogen on the nitrogen atom.

Suitable examples of the amide-based solvent include an acid amide derivative represented by Formula (Z) below.

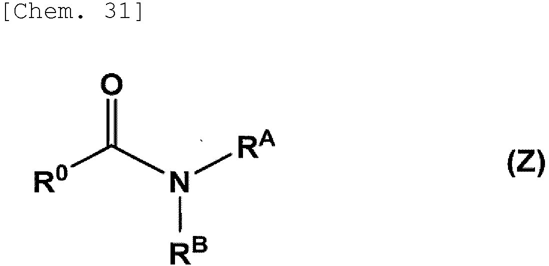

In Formula (Z), R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by Formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among them, N,N-dimethylpropionamide and N,N-dimethylisobutyramide are particularly preferred, and N,N-dimethylpropionamide is more preferred.

The acid amide derivative represented by Formula (Z) may be synthesized by a substitution reaction between a corresponding carboxylic acid ester and an amine, or a commercially available product may be used.

Another example of the preferred amide-based solvent is a lactam compound represented by Formula (Y).

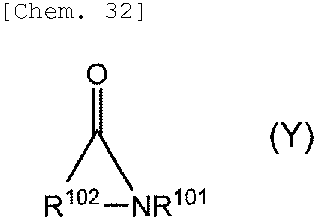

In Formula (Y), R¹⁰¹ represents a hydrogen atom or an alkyl group having 1 to 6 carbon atoms, and R¹⁰² represents an alkylene group having 1 to 6 carbon atoms or a group represented by the following Formula (Y1).

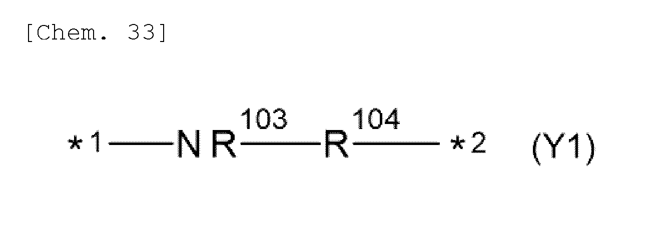

Specific examples of the alkyl group having 1 to 6 carbon atoms in R¹⁰² include a methyl group, an ethyl group, an n-propyl group, and an n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

In Formula (Y1), R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).

Specific examples of the lactam compound represented by Formula (Y) include an α-lactam compound, a β-lactam compound, a γ-lactam compound, and a δ-lactam compound, and these compounds can be used singly or in combination of two or more kinds thereof.

In a preferred aspect, the lactam compound represented by Formula (Y) contains 1-alkyl-2 pyrrolidone (N-alkyl-γ-butyrolactam), in a more preferred aspect, N-methylpyrrolidone (NMP) or N-ethylpyrrolidone (NEP) is contained, and in a still more preferred aspect, N-methylpyrrolidone (NMP) is contained.

As a preferred aspect of the compound represented by Formula (Y), for example, 1,3-dimethyl -2 imidazolidinone may also be mentioned.

In the component [II], it is more preferable to use the acid amide derivative represented by Formula (Z) in consideration of the operational restriction based on the regulations on use for chemical substances.

The content of the amide-based solvent in the releasing and dissolving composition may be 60 mass% or less when the aprotic solvent is 100 mass% in the releasing and dissolving composition.

The content of the amide-based solvent is preferably 5 mass% or more, more preferably 20 mass% or more, and is preferably 60 mass% or less, more preferably less than 60 mass%, still more preferably 50 mass% or less relative to 100 mass% of the aprotic solvent.

In the present invention, the content of the solvent to be mixed is defined by a ratio when the aprotic solvent that is a solvent having no hydroxyl group (-OH) is 100 mass%.

Thus, protic solvents such as water, methanol, and 1-methoxy-2-propanol are not contained based on a content ratio.

In the present invention, the aprotic solvent refers to, for example, N, N-dimethylpropionamide, p-menthane, limonene, dipropylene glycol dimethyl ether, butyl acetate, and the like, and the mixing ratio can be determined based on the total amount thereof.

### <<Component [III]: Solvent Represented by Any of Formulae (L0) to (L4)>>

The solvent represented by any one of the following formulas (L0) to (L4) is effective as a component for swelling the adhesive layer and releasing the adhesive layer from the semiconductor substrate.

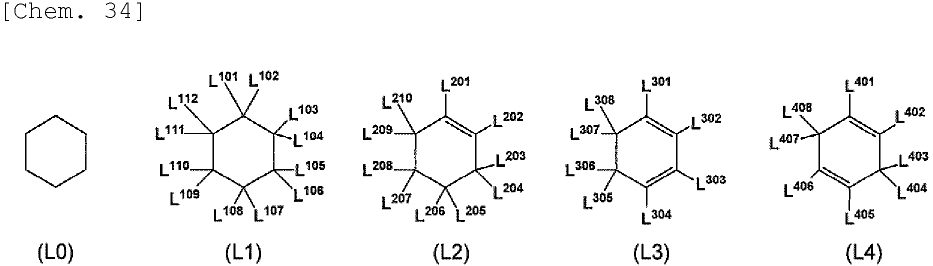

In Formulae (L1) to (L4) above, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms.

The alkyl group may be a linear, branched, or cyclic alkyl group, but is preferably a linear or branched alkyl group.

Specific examples of the linear or branched alkyl group include, but are not limited to, a methyl group, an ethyl group, an n-propyl group, an i-propyl group, an n-butyl group, an i-butyl group, an s-butyl group, and a t-butyl group.

Among them, a methyl group, an ethyl group, an n-propyl group, or an isopropyl group is preferred, and a methyl group and an isopropyl group are more preferred, from the viewpoint of realizing releasing of the adhesive layer in a shorter time.

Specific examples of the cyclic alkyl group include, but are not limited to, a cyclopropyl group, a cyclobutyl group, a 1-methyl-cyclopropyl group, a 2-methyl-cyclopropyl group, and a cyclopentyl group.

The alkenyl group having 2 to 5 carbon atoms may be linear, branched, or cyclic, and specific examples thereof include, but are not limited to, an ethenyl group, an n-1-propenyl group, an n-2-propenyl group, a 1-methylethenyl group, an n-1-butenyl group, an n-2-butenyl group, an n-3-butenyl group, a 2-methyl-1-propenyl group, a 2-methyl-2-propenyl group, a 1-ethylethenyl group, a 1-methyl-1-propenyl group, a 1-methyl-2-propenyl group, and an n-1-pentenyl group.

Among them, an ethenyl group, a 1-ethylethenyl group, and a 2-methylethenyl group are preferred, and a 1-methylethenyl group is more preferred, from the viewpoint of reproducibly realizing releasing of the adhesive layer in a shorter time.

The alkynyl group having 2 to 5 carbon atoms may be linear, branched, or cyclic, and specific examples thereof include, but are not limited to, an ethynyl group, an n-1-propynyl group, an n-2-propynyl group, an n-1-butynyl group, an n-2-butynyl group, an n-3-butynyl group, a 1-methyl-2-propynyl group, an n-1-pentynyl group, an n-2-pentynyl group, an n-3-pentynyl group, an n-4-pentynyl group, a 1-methyl-n-butynyl group, a 2-methyl-n-butynyl group, a 3-methyl-n-butynyl group, and a 1,1-dimethyl-n-propynyl group.

Among them, an ethynyl group and a 2-methylethynyl group are preferred from the viewpoint of reproducibly realizing releasing of the adhesive layer in a shorter time.

From the viewpoint of reproducibly realizing releasing of the adhesive layer in a shorter time, preferably, one or two of L¹⁰¹ to L¹¹² are each independently an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L¹⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L¹⁰¹ and L¹⁰⁷ are each independently an alkyl group having 1 to 5 carbon atoms, an alkenyl group having 2 to 5 carbon atoms, or an alkynyl group having 2 to 5 carbon atoms, and the remaining Ls are hydrogen atoms; and still more preferably, L¹⁰¹ is an alkyl group having 1 to 5 carbon atoms or an alkenyl group having 2 to 5 carbon atoms, and the remaining Ls are hydrogen atoms, or, L¹⁰¹ and L¹⁰⁷ are each independently an alkyl group having 1 to 5 carbon atoms or an alkenyl group having 2 to 5 carbon atoms, and the remaining Ls are hydrogen atoms.

From the viewpoint of reproducibly realizing releasing of the adhesive layer in a shorter time, preferably, one or two of L²⁰¹ to L²¹⁰ are each independently an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L²⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L²⁰¹ and L²⁰⁵ are each independently an alkyl group having 1 to 5 carbon atoms, an alkenyl group having 2 to 5 carbon atoms, or an alkynyl group having 2 to 5 carbon atoms, and the remaining Ls are hydrogen atoms; and still more preferably, L²⁰¹ and L²⁰⁵ are each independently an alkyl group having 1 to 5 carbon atoms or an alkenyl group having 2 to 5 carbon atoms, and the remaining Ls are hydrogen atoms; yet still more preferably, L²⁰¹ is an alkyl group having 1 to 5 carbon atoms and L²⁰⁵ is an alkenyl group having 2 to 5 carbon atoms, and the remaining Ls are hydrogen atoms.

From the viewpoint of reproducibly realizing releasing of the adhesive layer in a shorter time, preferably, one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L³⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L³⁰¹ and L³⁰⁴ are each independently an alkyl group having 1 to 5 carbon atoms, an alkenyl group having 2 to 5 carbon atoms, or an alkynyl group having 2 to 5 carbon atoms, and the remaining Ls are hydrogen atoms; still more preferably, L³⁰¹ is an alkyl group having 1 to 5 carbon atoms or an alkenyl group having 2 to 5 carbon atoms, and the remaining Ls are hydrogen atoms, or, L³⁰¹ and L³⁰⁴ are each independently an alkyl group having 1 to 5 carbon atoms or an alkenyl group having 2 to 5 carbon atoms, and the remaining Ls are hydrogen atoms; yet still more preferably, L³⁰¹ is an alkyl group having 1 to 5 carbon atoms and the remaining Ls are hydrogen atoms, or L³⁰¹ and L³⁰⁴ are each independently an alkyl group having 1 to 5 carbon atoms and the remaining Ls are hydrogen atoms.

From the viewpoint of reproducibly realizing releasing of the adhesive layer in a shorter time, preferably, one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L⁴⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L⁴⁰¹ and L⁴⁰⁵ are each independently an alkyl group having 1 to 5 carbon atoms, an alkenyl group having 2 to 5 carbon atoms, or an alkynyl group having 2 to 5 carbon atoms, and the remaining Ls are hydrogen atoms; still more preferably, L⁴⁰¹ is an alkyl group having 1 to 5 carbon atoms or an alkenyl group having 2 to 5 carbon atoms, and the remaining Ls are hydrogen atoms, or, L⁴⁰¹ and L⁴⁰⁵ are each independently an alkyl group having 1 to 5 carbon atoms or an alkenyl group having 2 to 5 carbon atoms, and the remaining Ls are hydrogen atoms; yet still more preferably, L⁴⁰¹ is an alkyl group having 1 to 5 carbon atoms and the remaining Ls are hydrogen atoms, or L⁴⁰¹ and L⁴⁰⁵ are each independently an alkyl group having 1 to 5 carbon atoms and the remaining Ls are hydrogen atoms.

Preferred examples of the organic solvent represented by Formulae (L0) to (L4) include cyclohexane, p-menthane, isopropyl cyclohexane and limonene from the viewpoint of reproducibly realizing the releasing of the adhesive layer in a shorter time and the viewpoint of ease of availability of the compound.

The content of the solvent represented by any one of Formulae (L0) to (L4) (hereinafter, Formulae (L0) to (L4) are also collectively referred to as Formula (L0) or the like) in the releasing and dissolving composition may be 20 mass% or more when the aprotic solvent is 100 mass% in the releasing and dissolving composition.

The content of the solvent represented by Formula (L0) or the like in the releasing and dissolving composition is preferably 20 mass% or more, more preferably 30 mass% or more, still more preferably 35 mass% or more, and preferably 80 mass% or less, more preferably 60 mass% or less when the aprotic solvent is 100 mass% in the releasing and dissolving composition. The upper limit and the lower limit may be combined in any manner.

Note that an arbitrary amount of the solvent of the component [IV] represented by Formula (T) below or Formula (G) below is contained in the releasing and dissolving composition and may be mixed with the solvent of the component [III] represented by Formula (L0) or the like. In this case, the content obtained by adding the component [III] and the component [IV] is preferably 30 to 90 mass% when the aprotic solvent is 100 mass%.

### <<Component [IV]: Solvent Represented by Formula (T) or Formula (G)>>

The solvent represented by the following Formula (T) or the following Formula (G) is effective as an adjustment component for enhancing the compatibility between the amide-based solvent as the component [II] and the solvent represented by Formula (L0) above or the like as the component [III] in the releasing and dissolving composition containing the quaternary ammonium salt as the component [I].

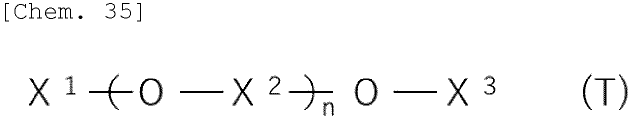

In Formula (T), X¹ and X³ each independently represent an alkyl group or an acyl group (X⁴-C(=O)-), X² represents an alkylene group, n represents 2 or 3. X⁴ represents an alkyl group.

Examples of the alkyl group represented by X₁ and X₃ include an alkyl group having 1 to 4 carbon atoms, and more specific examples thereof include a methyl group, an ethyl group, a propyl group, an isopropyl group, an n-butyl group, an isobutyl group, a sec-butyl group, and a t-butyl group.

Examples of the alkylene group represented by X₂ include a methylene group, a 1,2-ethylene group, a 1,3-propylene group, and a 1,2-propylene group.

Examples of the alkyl group represented by X₄ include an alkyl group having 1 to 4 carbon atoms, and examples thereof include the same alkyl groups as X₁ and X₃.

Preferred examples of the solvent represented by Formula (T) include dipropylene glycol dimethyl ether, diethylene glycol dimethyl ether, and diethylene glycol diethyl ether.

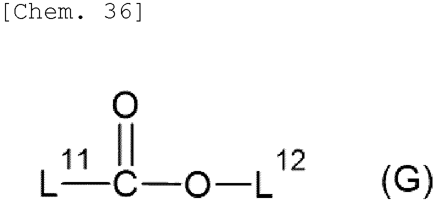

In Formula (G), L¹¹ and L¹² each independently represent an alkyl group having 1 to 6 carbon atoms, and a total number of carbon atoms of the alkyl group in L¹¹ and the alkyl group in L¹² is 7 or less.

In Formula (G), L¹¹ and L¹² each independently represent an alkyl group having 1 to 6 carbon atoms, and a total number of carbon atoms of the alkyl group in L¹¹ and the alkyl group in L¹² is 7 or less. The number of carbon atoms is set to the range described above, and thus the releasing of the adhesive layer in a short time can be realized with good reproducibility.

The alkyl group may be a linear, branched, or cyclic alkyl group, but is preferably a linear or branched alkyl group, more preferably a linear alkyl group.

Specific examples of the linear or branched alkyl group include, but are not limited to, a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, and 1-ethyl-2-methyl-n-propyl group.

Specific examples of the cyclic alkyl group include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

From the viewpoint of realizing releasing of the adhesive layer in a shorter time with good reproducibility, L¹¹ is preferably a methyl group, and L¹² is preferably a butyl group or a pentyl group.

From the viewpoint of realizing releasing of the adhesive layer in a shorter time with good reproducibility and from the viewpoint of ease of availability of the compound, preferred examples of the organic solvent represented by Formula (G) include butyl acetate and pentyl acetate.

The content of the solvent represented by Formula (T) or (G) in the releasing and dissolving composition may be 20 mass% or more when the aprotic solvent is 100 mass% in the releasing and dissolving composition.

The content of the solvent represented by Formula (T) or (G) in the releasing and dissolving composition is preferably 20 mass% or more, more preferably 25 mass% or more, still more preferably 30 mass% or more, and preferably 60 mass% or less, more preferably 50 mass% or less when the aprotic solvent is 100 mass% in the releasing and dissolving composition. The upper limit and the lower limit may be combined in any manner.

### <<Releasing and Dissolving Step>>

In the present invention, the releasing and dissolving composition is continuously brought into contact with the adhesive layer on the semiconductor substrate. This cleaning operation is performed, thereby simultaneously performing an operation of swelling and releasing the adhesive layer and an operation of dissolving the adhesive layer. The operation of swelling and releasing the adhesive layer is performed simultaneously with the operation of dissolving the adhesive layer by one cleaning operation using a cleaning composition, and thus the adhesive layer can be more cleanly removed (cleaned) from the semiconductor substrate in a shorter time by a simple cleaning operation.

Note that, in the present invention, the removal (cleaning) means that the adhesive layer is eliminated from the semiconductor substrate, and both a case where the adhesive layer is swollen and released from the semiconductor substrate and a case where the adhesive layer dissolves in the solution to disappear from the semiconductor substrate are included in the "removal (cleaning)".

The method for continuously bring the adhesive layer on the semiconductor substrate into contact with the releasing and dissolving composition is not particularly limited as long as the adhesive layer on the semiconductor substrate is brought into contact with the releasing and dissolving composition with a temporal continuity, and the temporal continuity includes a case where the adhesive layer is always brought into contact with the releasing and dissolving composition, a case where, after the contact between the adhesive layer and the organic solvent is performed for a certain period of time, the contact is temporarily suspended, and the contact is performed again or repeated, a case where the entire adhesive layer on the semiconductor substrate is brought into contact with the releasing and dissolving composition, and a case where a part of the adhesive layer is brought into contact with the releasing and dissolving composition, but from the viewpoint of realizing more effective cleaning with good reproducibility, an aspect in which the adhesive layer on the semiconductor substrate is always brought into contact with the releasing and dissolving composition is preferred, and an aspect in which the entire adhesive layer on the semiconductor substrate is brought into contact with the releasing and dissolving composition is preferred.

Therefore, in a preferred aspect of the present invention, the adhesive layer on the semiconductor substrate is swollen and dissolved by immersing the adhesive layer in the releasing and dissolving composition and the adhesive layer is removed from the semiconductor substrate, or the adhesive layer on the semiconductor substrate is swollen and dissolved by continuously supplying the releasing and dissolving composition onto the adhesive layer and the adhesive layer is removed from the semiconductor substrate.

In order to immerse the adhesive layer on the semiconductor substrate in the releasing and dissolving composition, for example, the semiconductor substrate with the adhesive layer may be immersed in the releasing and dissolving composition.

The immersion time is a time until swelling and dissolving of the adhesive layer occur and the adhesive layer is released from the semiconductor substrate, and is not particularly limited, but is 5 seconds or longer from the viewpoint of realizing more effective cleaning with good reproducibility, and is 5 minutes or shorter from the viewpoint of throughput in the process.

When the adhesive layer on the semiconductor substrate is immersed in the releasing and dissolving composition, the removal (cleaning) of the adhesive layer may be promoted by moving the semiconductor substrate with the adhesive layer in the releasing and dissolving composition, subjecting the releasing and dissolving composition to convection, vibrating the releasing and dissolving composition by ultrasonic waves, or the like.

In order to move the semiconductor substrate with the adhesive layer in the releasing and dissolving composition, for example, a swing cleaning machine, a paddle-type cleaning machine, or the like may be used, and when such a cleaning machine is used, a table on which the semiconductor substrate with the adhesive layer is placed moves or rotates vertically or horizontally, such that the adhesive layer on the semiconductor substrate is relatively subjected to convection, or the adhesive layer on the semiconductor substrate is subjected to convection generated by its the movement or rotation. Thus, not only the swelling and dissolving of the adhesive layer on the semiconductor substrate, but also the releasing and dissolving of the adhesive layer from the semiconductor substrate are promoted.

In order to subject the releasing and dissolving composition to convection, for example, in a state where the semiconductor substrate with the adhesive layer is fixed to a stage or the like, a convection cleaning machine capable of realizing a state in which convection of the releasing and dissolving composition around the semiconductor substrate is performed by a stirrer may be typically used in addition to the swing cleaning machine and the paddle-type cleaning machine described above.

In order to vibrate the releasing and dissolving composition by ultrasonic waves, an ultrasonic cleaning machine or an ultrasonic probe may be used, and the conditions thereof are ordinarily 20 kHz to 5 MHz.

In order to continuously supply the releasing and dissolving composition onto the adhesive layer on the semiconductor substrate, the releasing and dissolving composition may be continuously applied toward the adhesive layer on the semiconductor substrate. As an example, in a case where the adhesive layer on the semiconductor substrate faces upward, for example, a rod-like or atomized, preferably rod-like releasing and dissolving composition is continuously supplied onto the adhesive layer on the semiconductor substrate from above (including obliquely above) the adhesive layer on the semiconductor substrate by a nozzle of a cleaning machine or the like. The temporal continuity in this case includes not only a case where the releasing and dissolving composition is always supplied onto the adhesive layer on the semiconductor substrate, but also, for example, a case where the supply of the releasing and dissolving composition is stopped once after the supply is performed for a certain period of time, and the supply is performed again, or a case where the supply is repeated. From the viewpoint of realizing more effective cleaning with good reproducibility, it is preferable that the releasing and dissolving composition is always supplied onto the adhesive layer on the semiconductor substrate.

When the releasing and dissolving composition is supplied in a rod shape onto the adhesive layer on the semiconductor substrate, the flow rate is ordinarily 200 to 500 mL/min.

In an aspect of the present invention, in order to achieve a state of always being in contact with the releasing and dissolving composition, the adhesive layer on the semiconductor substrate may be brought into contact with steam of the releasing and dissolving composition by using, for example, a steam cleaning machine.

When the method for cleaning a semiconductor according to the present invention is used, as described above, the swelling, releasing, and dissolving of the adhesive layer are simultaneously performed, such that the adhesive layer can be removed (cleaned) form the semiconductor substrate more clearly in a shorter time by a simple cleaning operation. In addition to this effect, the damage of the dicing tape in the cleaning step can be prevented by using the method for cleaning a semiconductor of the present invention.

For example, after the semiconductor wafer is polished and thinned, the thinned semiconductor wafer is mounted on the dicing tape, and then the semiconductor wafer and the support are separated (released). After the support is separated (released), the adhesive layer remaining on the side of the semiconductor wafer is eliminated from the semiconductor wafer, and thus cleaned with the cleaning agent composition. In this case, when a cleaning agent composition of a type that dissolves and eliminates an adhesive residue, such as the cleaning agent compositions of Patent Literatures 1 and 2, is used as the cleaning agent composition, a surface of the dicing tape is changed, and the dicing tape is damaged.

However, when the semiconductor substrate with the adhesive layer is cleaned using the releasing and dissolving composition of the present invention, most of the adhesive layer can be released in a short time, and a small amount of the adhesive layer remaining after the releasing is also dissolved by the component dissolved in the releasing and dissolving composition, such that the entire removal (cleaning) time for eliminating the adhesive layer can be shortened, and the damage of the dicing tape in the cleaning step can be effectively prevented. In addition, the releasing and dissolving composition of the present invention contains not only a component for dissolving the adhesive layer but also a component for swelling and releasing the adhesive layer, and as a result, a proportion of the dissolving component, i.e. the component [I] (quaternary ammonium salt) in the composition can be reduced, which also effectively contributes to preventing the dicing tape from being damaged.

When the step of removing the adhesive layer is performed using the releasing and dissolving composition of the present invention, damage to the dicing tape can be effectively prevented.

The method for cleaning a semiconductor substrate of the present invention may include a step of eliminating the released adhesive layer.

The method for eliminating the released adhesive layer is not particularly limited as long as the adhesive layer released from the semiconductor substrate is removed, and in a case where the semiconductor substrate with the adhesive layer is immersed in the releasing and dissolving composition, the released adhesive layer present in the releasing and dissolving composition may be removed without taking out the semiconductor substrate from the releasing and dissolving composition. Alternatively, the semiconductor substrate may be taken out from the releasing and dissolving composition, and the released adhesive layer may be eliminated by separating the semiconductor substrate from the released adhesive layer. In this case, the semiconductor substrate is simply taken out from the releasing and dissolving composition, and thus the released adhesive layer may naturally remain in the releasing and dissolving composition, and most of the adhesive layer may be eliminated.

Specific examples of the method for eliminating the released adhesive layer include, but are not limited to, a method for eliminating the released adhesive layer by adsorbing and sucking the adhesive layer using a device, a method for eliminating the released adhesive layer by blowing off the adhesive layer with gas such as an air gun, and a method for eliminating the released adhesive layer by centrifugal force or the like by moving or rotating the semiconductor substrate vertically or horizontally.

After the adhesive layer released from the semiconductor substrate is removed, if necessary, the semiconductor substrate is dried or the like according to a standard method.

### (Releasing and Dissolving Composition)

The releasing and dissolving composition used in the method for cleaning a semiconductor substrate of the present invention is also an object of the present invention.

The releasing and dissolving composition of the present invention is used for removing (cleaning) the adhesive layer on the semiconductor substrate from the semiconductor substrate, and preferred aspects and conditions are as described above. The releasing and dissolving composition of the present invention can be produced by mixing the solvents constituting the composition in any order, if necessary. In this case, filtration or the like may be performed, if necessary.

A preferred embodiment of the releasing and dissolving composition of the present invention is, for example, a releasing and dissolving composition in which when the releasing and dissolving composition contains the component [I], the component [II], the component [III], and the component [IV], the component [III] is contained in an amount of 20 mass% or more and the component [IV] is contained in an amount of 20 mass% or more when the aprotic solvent is 100 mass%.

Further, another preferred embodiment of the releasing and dissolving composition of the present invention is, for example, a releasing and dissolving composition in which when the releasing and dissolving composition contains the component [I], the component [II], the component [III], and the component [IV], the component [II] is contained in an amount of 60 mass% or less, the component [III] is contained in an amount of 20 mass% or more, and the component [IV] is contained in an amount of 20 mass% or more when the aprotic solvent is 100 mass%.

Furthermore, another preferred embodiment of the releasing and dissolving composition of the present invention is, for example, a releasing and dissolving composition in which when the releasing and dissolving composition contains the component [I], the component [II], the component [III], and the component [IV], the component [II] is contained in an amount of less than 60 mass%, the component [III] is contained in an amount of 20 mass% or more, and the component [IV] is contained in an amount of 20 mass% or more when the aprotic solvent is 100 mass%.

In addition, another preferred embodiment of the releasing and dissolving composition of the present invention is, for example, a releasing and dissolving composition in which when the releasing and dissolving composition contains the component [I], the component [II], the component [III], and the component [IV], the component [II] is contained in an amount of 50 mass% or less, the component [III] is contained in an amount of 20 mass% or more, and the component [IV] is contained in an amount of 20 mass% or more when the aprotic solvent is 100 mass%.

### (Method for Producing Processed Semiconductor Substrate)

The use of the method for cleaning a semiconductor substrate of the present invention described above makes it possible to efficiently eliminate the adhesive layer on the substrate of the semiconductor substrate, particularly the adhesive layer which is a cured film formed from a siloxane-based adhesive containing a polyorganosiloxane component (A') cured by a hydrosilylation reaction, and it can be expected to produce an excellent semiconductor element with high efficiency.

In the method for producing a processed semiconductor substrate of the present invention, for example, after a semiconductor wafer is polished and thinned, a support is separated (released) from the processed semiconductor wafer after thinning, and then an adhesive layer remaining on the side of the semiconductor wafer is removed (cleaned) by using the method for cleaning a semiconductor substrate of the present invention, and thus a semiconductor substrate having a cleaned surface without the remaining adhesive layer can be produced.

As described above, examples of use of the method for cleaning a semiconductor substrate of the present invention in a semiconductor process include use in a method for producing a processed semiconductor substrate such as thinning used in a semiconductor package technique such as TSV.

In addition to the silicon semiconductor substrate such as the silicon wafer described above, examples of the semiconductor substrate to be cleaned by the cleaning method of the present invention include various substrates such as a germanium substrate, a gallium-arsenic substrate, a gallium-phosphorus substrate, a gallium-arsenic-aluminum substrate, an aluminum-plated silicon substrate, a copper-plated silicon substrate, a silver-plated silicon substrate, a gold-plated silicon substrate, a titanium-plated silicon substrate, a silicon nitride film-formed silicon substrate, a silicon oxide film-formed silicon substrate, a polyimide film-formed silicon substrate, a glass substrate, a quartz substrate, a liquid crystal substrate, and an organic EL substrate.

A preferred embodiment of the method for producing a processed semiconductor substrate of the present invention is, for example, a method for producing a processed semiconductor substrate including:
a first step of producing a laminate including a semiconductor substrate, a support substrate, and an adhesive layer formed from an adhesive composition;
a second step of processing the semiconductor substrate of the produced laminate;
a third step of separating the semiconductor substrate and the adhesive layer from the support substrate; and
a fourth step of releasing and dissolving the adhesive layer on the semiconductor substrate using a releasing and dissolving composition to remove the adhesive layer.

Here, the releasing and dissolving composition is as described in the section of < Releasing and Dissolving Composition> above.

In the fourth step, the method for cleaning a semiconductor substrate of the present invention is used.

Hereinafter, each of the steps will be described in detail.

### <First Step>

As the adhesive composition used for forming the adhesive layer in the first step, the above-described various adhesives can be used, but the method for cleaning a semiconductor substrate of the present invention is effective for eliminating an adhesive layer formed from a polysiloxane adhesive, and is more effective for eliminating an adhesive layer from a polysiloxane-based adhesive containing a component (A) which is cured by a hydrosilylation reaction.

Therefore, an example in which the adhesive layer is eliminated by the cleaning method of the present invention when a processed semiconductor substrate is produced using an adhesive layer formed using a polysiloxane-based adhesive (adhesive composition) will be described below, but the present invention is not limited thereto.

The first step of producing a laminate including a semiconductor substrate, a support substrate, and an adhesive layer formed from an adhesive composition will be described below.

In an aspect, the first step includes a step of applying an adhesive composition to a surface of a semiconductor substrate or a support substrate to form an adhesive coating layer, and a step of bonding the semiconductor substrate and the support substrate with the adhesive coating layer therebetween, bringing the semiconductor substrate and the support substrate into close contact with each other by applying a load in a thickness direction while performing at least one of a heat treatment and a decompression treatment, and then performing a post-heat treatment to form a laminate.

In another aspect, the first step includes, for example, a step of applying an adhesive composition to a circuit surface of a wafer on a semiconductor substrate and heating the adhesive composition to form an adhesive coating layer, a step of applying a release agent composition to a surface of a support substrate and heating the release agent composition to form a release agent coating layer, and a step of bringing the adhesive coating layer of the semiconductor substrate and the release agent coating layer of the support substrate into close contact with each other by applying a load in a thickness direction while performing at least one of a heat treatment and a decompression treatment, and then performing a post-heat treatment to form a laminate. Note that, although the adhesive composition and the release agent composition are applied to the semiconductor substrate and the support substrate, respectively, and the adhesive composition and the release agent composition are heated, the adhesive composition and the release agent composition may be sequentially applied and heated to either one of the substrates.

In each of the aspects, which treatment condition of heat treatment, decompression treatment, and combination use of both is adopted is determined in consideration of various circumstances such as the type of the adhesive composition, the specific composition of the release agent composition, the compatibility of the films prepared from both compositions, the film thickness, and the required adhesive strength.

Here, for example, the semiconductor substrate is a wafer, and the support substrate is a support. A target to which the adhesive composition is applied may be either one or both of the semiconductor substrate and the support substrate.

Examples of the wafer include, but are not limited to, a silicon wafer or a glass wafer having a diameter of about 300 mm and a thickness of about 770 µm.

Particularly, the method for cleaning a semiconductor substrate according to the present invention can effectively clean a semiconductor substrate with bumps as well.

Specific examples of the semiconductor substrate with bumps include a silicon wafer having bumps such as a ball bump, a printed bump, a stud bump, and a plated bump, and ordinarily, the semiconductor substrate with bumps is appropriately selected from conditions of a bump height of about 1 to 200 µm, a bump diameter of 1 to 200 µm, and a bump pitch of 1 to 500 µm.

Specific examples of the plated bump include, but are not limited to, alloy plating mainly containing Sn, such as SnAg bumps, SnBi bumps, Sn bumps, and AuSn bumps.

The support (carrier) is not particularly limited, and examples thereof include, but are not limited to, a silicon wafer having a diameter of 300 mm and a thickness of about 700 µm.

Examples of the release agent composition include a composition containing a release agent component used for this type of application.

The application method is not particularly limited, and is ordinarily a spin coating method. Note that a method of separately forming a coating film by a spin coating method or the like and attaching the sheet-like coating film may be adopted, which is also referred to as a coating or coating film.

The heating temperature of the applied adhesive composition varies depending on the type and amount of the adhesive component contained in the adhesive composition, whether or not a solvent is contained, the desired thickness of the adhesive layer, and the like, and thus cannot be generally specified. The heating temperature is ordinarily 80 to 150°C, and the heating time is ordinarily 30 seconds to 5 minutes.

The heating temperature of the applied adhesive composition varies depending on the types and amounts of the crosslinking agent, the acid generator, and the acid, whether or not a solvent is contained, a desired thickness of the release layer, and the like, and thus cannot be generally specified. However, the heating temperature of the applied release agent composition is 120° C or higher from the viewpoint of realizing preferred curing, and is preferably 260° C or lower from the viewpoint of preventing excessive curing, and the heating time is ordinarily 1 to 10 minutes.

The heating can be performed using a hot plate, an oven, or the like.

The film thickness of the adhesive coating layer formed by applying the adhesive composition and heating the adhesive composition is ordinarily 5 to 500 µm.

The film thickness of the release agent coating layer formed by applying the release agent composition and heating the release agent composition is ordinarily 5 to 500 µm.

The heat treatment is appropriately determined from a range of ordinarily 20 to 150° C in consideration of the viewpoint of softening the release agent coating layer to suitably bond the adhesive coating layer to the release agent coating layer, the viewpoint of suitably curing the release agent coating layer, and the like. Particularly, the heating temperature is preferably 130° C or lower and more preferably 90° C or lower from the viewpoint of suppressing and avoiding excessive curing and unnecessary degeneration of the adhesive component and the release agent component, and the heating time is ordinarily 30 seconds or longer and preferably 1 minute or longer from the viewpoint of reliably exhibiting the adhesive ability and the releasability, and is ordinarily 10 minutes or shorter and preferably 5 minutes or shorter from the viewpoint of suppressing degeneration of the adhesive layer or other members.

In the decompression treatment, the semiconductor substrate, the adhesive coating layer, and the support substrate, or the semiconductor substrate, the adhesive coating layer, the release agent coating layer, and the support substrate may be exposed to an atmospheric pressure of 10 to 10,000 Pa. The time for the decompression treatment is ordinarily 1 to 30 minutes.

In a preferred aspect of the present invention, the substrate and the coating layer or the coating layers are preferably bonded to each other by a decompression treatment, and are more preferably bonded to each other by combining a heat treatment and a decompression treatment.

The load in the thickness direction of the semiconductor substrate and the support substrate is not particularly limited as long as the load does not adversely affect the semiconductor substrate and the support substrate and the layer therebetween and can allow the semiconductor substrate and the support substrate to firmly adhere to each other, but is ordinarily within a range of 10 to 1,000 N.

The post-heating temperature is preferably 120°C or higher from the viewpoint of obtaining a sufficient curing rate and the like, and is preferably 260°C or lower from the viewpoint of preventing degeneration of the substrate, the adhesive component, the release agent component, and the like. The heating time is ordinarily 1 minute or longer from the viewpoint of realizing preferred bonding of wafers by curing, and is preferably 5 minutes or longer from the viewpoint of stabilizing the physical properties of the adhesive, and is ordinarily 180 minutes or shorter, and preferably 120 minutes or shorter from the viewpoint of avoiding an adverse effect on the adhesive layer due to excessive heating. The heating can be performed using a hot plate, an oven, or the like.

Note that one object of the post-heat treatment is to more suitably cure the adhesive component (S).

### <Second Step>

Next, the second step of processing the semiconductor substrate of the laminate formed by the method described above will be described.

Examples of the processing applied to the laminate used in the present invention include processing of the back surface opposite to the circuit surface of the front surface of the semiconductor substrate, and typically includes thinning of the wafer by polishing the back surface of the wafer. Such a thinned wafer is used to form a through-silicon via (TSV) or the like, and then the thinned wafer is released from the support substrate to form a laminate of the wafers, and the wafers are three-dimensionally mounted. Before and after that, a wafer-back electrode and the like are also formed. Heat of 250 to 350°C is applied to the thinning of the wafer and the TSV process in a state of adhering to the support, and the adhesive layer included in the laminate used in the present invention has heat resistance to the heat.

For example, a wafer having a diameter of about 300 mm and a thickness of about 770 µm can be thinned to a thickness of about 80 µm to 4 µm by polishing the back surface opposite to the circuit surface of the front surface.

### <Third Step>

The third step of separating the processed semiconductor substrate and the adhesive layer from the support substrate will be described.

In the third step, the processed semiconductor substrate and the adhesive layer are separated from the support substrate. At this time, in a case where the release layer is included in the laminate, the release layer is ordinarily eliminated together with the support substrate.

As a method for separating the processed semiconductor substrate and the adhesive layer from the semiconductor substrate, releasing may be performed between the adhesive layer and the release layer or the support substrate in contact therewith. Examples of the releasing method include, but are not limited to, laser releasing, mechanical releasing with equipment having a sharp portion, and manual releasing.

### <Fourth Step>

Next, the fourth step of removing the adhesive layer on the processed semiconductor substrate and cleaning the processed semiconductor substrate will be described.

The fourth step is a step of eliminating the adhesive layer on the semiconductor substrate by the method for cleaning a semiconductor substrate of the present invention, and specifically, for example, the adhesive layer on the thinned substrate is cleanly eliminated in a short time by the cleaning method of the present invention. The conditions involved therein are as described above.

As described above, swelling and dissolution act simultaneously on the adhesive layer only by performing a cleaning operation using the releasing and dissolving composition of the present invention. Thus, in the fourth step, the adhesive layer on the semiconductor substrate can be more cleanly removed in a short time.

The method for producing a processed semiconductor substrate of the present invention includes the first step to the fourth step described above, and may include steps other than these steps. In addition, the above-described constituent elements and method elements related to the first step to the fourth step may be variously changed without departing from the gist of the present invention.

### Examples

Hereinafter, the content and effect of the present invention will be described in more detail with reference to Examples, but the present invention is not limited thereto. The apparatuses used are as follows.

### [Apparatus]

(1) Stirrer A: planetary centrifugal mixer ARE-500, manufactured by Thinky Corporation
(2) Stirrer B: Mix Roter Variable VMR-5R, manufactured by AS ONE Corporation
(3) Viscometer: rotational viscometer TVE-22H, manufactured by Toki Sangyo Co., Ltd.
(4) Optical microscope: semiconductor/FPD inspection microscope MX61L, manufactured by Olympus Corporation

### [1] Preparation of Adhesive Composition 1

### Example 1

A 600 mL stirring vessel dedicated for the stirrer A was charged with 230.01 g of a p-menthane solution (concentration: 81.7 mass%) of an MQ resin having a polysiloxane skeleton and a vinyl group (manufactured by Wacker Chemie AG) as the component (a1), 78.06 g of a polyorganosiloxane represented by Formula (M1) as the component (B) (trade name: GENIOPLAST GUM, manufactured by Wacker Chemie AG, complex viscosity: 6000 Pa·s, weight-average molecular weight: 642,000 (dispersity: 2.6)), 164.62 g of p-menthane (manufactured by Nippon Terpene Chemicals, Inc.), and 23.13 g of n-decane (manufactured by Sankyo Chemical Co., Ltd.). A sequence of stirring the resultant mixture with the stirrer A for 5 minutes was repeated with a slight pause during the sequence for a total of 8 times to form a mixture (I) (stirring time: total 40 minutes).

37.58 g of SiH group-containing linear polydimethylsiloxane (manufactured by Wacker Chemie AG) having a viscosity of 100 mPa·s as the component (a2) and 54.93 g of vinyl group-containing linear polydimethylsiloxane (manufactured by Wacker Chemie AG) having a viscosity of 200 mPa·s as the component (a1) were added to the resultant mixture (I) to form a mixture (II).

0.87 g of 1,1-diphenyl-2-propyn-1-ol (manufactured by Tokyo Chemical Industry Co., Ltd.) as the component (A3), 0.87 g of 1-ethynyl-1-cyclohexanol (manufactured by Wacker Chemie AG) as the component (A3), and 1.73 g of p-menthane (manufactured by Nippon Terpene Chemicals, Inc.) were stirred with the stirrer B for 60 minutes to form a mixture (III).

2.89 g of the resultant mixture (III) was added to the mixture (II), and the mixture was stirred with the stirrer A for 5 minutes to form a mixture (IV).

0.139 g of a platinum catalyst (manufactured by Wacker Chemie AG) as the component (A2) and 10.41 g of vinyl group-containing linear polydimethylsiloxane (manufactured by Wacker Chemie AG) having a viscosity of 1000 mPa·s as the component (a1) were stirred with the stirrer A for 5 minutes to form a mixture (V).

8.79 g of the resultant mixture (V) was added to the mixture (IV), and the mixture was stirred with the stirrer A for 5 minutes to form a mixture (VI).

Finally, the resultant mixture (VI) was filtered through a nylon filter (300 mesh) to form an adhesive composition. In addition, the viscosity of the resultant adhesive composition was 2500 mPa·s.

### [4] Preparation of Cleaning Composition

### Example 2-1

2.80 g of N-methyl-2-pyrrolidone, 2.80 g of P-menthane, and 8.40 g of dipropylene glycol dimethyl ether were added to 0.42 g of tetrabutylammonium fluoride trihydrate (manufactured by KANTO CHEMICAL CO., INC.) and the mixture was stirred to form a cleaning composition.

### Examples 2-2 to 2-10 and Comparative Examples 1-1 to 1-10

Cleaning compositions were prepared in the same procedure as in Example 2-1 except that the compositions were adjusted to the compositions shown in Tables 1 to 3 (also collectively referred to as "Table 1", for example).

### Examples 2-11 to 2-13

Cleaning compositions were prepared in the same procedure as in Example 2-1 except that N-ethyl-2-pyrrolidone was used instead of N-methyl-2-pyrrolidone as the N-substituted amide compound of the component II and the compositions were adjusted to the compositions shown in Table 1, for example.

### Examples 2-14 to 2-15

Cleaning compositions were prepared in the same procedure as in Example 2-1 except that N,N-dimethylpropionamide was used instead of N-methyl-2-pyrrolidone as the N-substituted amide compound of the component II and the compositions were adjusted to the compositions shown in Table 1, for example.

### Examples 2-16 to 2-18

Cleaning compositions were prepared in the same procedure as in Example 2-1 except that 1,3-dimethyl-2-imidazolidinone was used instead of N-methyl-2-pyrrolidone as the N-substituted amide compound of the component II and the compositions were adjusted to the compositions shown in Table 1, for example.

### Example 2-19

A cleaning composition was prepared in the same procedure as in Example 2-1 except that limonene was used as the cyclic hydrocarbon of the component III and the composition was adjusted to be the composition shown in Table 1.

### Example 2-20

A cleaning composition was prepared in the same procedure as in Example 2-1 except that butyl acetate was used as the component IV instead of dipropylene glycol dimethyl ether and the composition was adjusted to the composition shown in Table 1, for example.

### Example 2-21

A cleaning composition was prepared in the same procedure as in Example 2-20 except that N,N-dimethylpropionamide was used instead of N-methyl-2-pyrrolidone as the N-substituted amide compound of the component II and the composition was adjusted to the composition shown in Table 1, for example.

### [3] Formation of Substrates for Evaluation

### Production Example 1

The adhesive composition prepared in Example 1 was spin-coated on a silicon wafer (4 cm×4 cm, thickness: 775 µm) as a device-side wafer. Then, the coated wafer was heated at 110°C for 1.5 minutes (preheat treatment), then heated at 200°C for 10 minutes, and thus a residual solvent on the wafer was removed and a thin film having a thickness of about 40 µm was formed on the wafer. Accordingly, a wafer having an adhesive layer was produced.

### [4] Measurement of Release Time

The wafer having an adhesive layer prepared in Production Example 1 was immersed in 7 mL of each of the cleaning compositions prepared in Examples 2-1 to 2-21 and Comparative Examples 1-1 to 1-10. The time until the adhesive layer was completely released from the wafer was taken as a release time. The results are shown in the following Tables 1 to 3. In Comparative Example 1-2 and Comparative Examples 1-4 to 1-6, turbidity occurred after TBAF was added in the test of [4]. Thus, the test of [4] was not performed (indicated by the abbreviation "N.A." in the table).

### [5] Confirmation of Presence or Absence of Residue After Separation

The wafer having an adhesive layer prepared in Production Example 1 was immersed in 7 mL of each of the cleaning compositions prepared in Examples 2-1 to 2-21 and Comparative Examples 1-1 to 1-10. When the adhesive layer was released within 1 minute after immersion in the cleaning composition, the released adhesive layer was removed with tweezers. After leaving for 1 minute from the start of immersion, the substrate was washed with isopropanol and ultrapure water, and the presence or absence of a residue on the substrate was confirmed with an optical microscope. The results are shown in the following Tables 1 to 3. In Comparative Example 1-2 and Comparative Examples 1-4 to 1-6, turbidity occurred after TBAF was added in the test of [4]. Thus, the test of [5] was not performed (indicated by the abbreviation "N.A." in the table). Further, in Comparative Examples 1-1 and 1-3, separation did not occur even after 300 seconds in the test of [4], Thus, the test of [5] was not performed (indicated by the abbreviation "N.A." in the table).

It was found that when the semiconductor substrate having the adhesive layer was cleaned using the releasing and dissolving composition of the present invention, the adhesive layer could be removed (cleaned) from the semiconductor substrate in a short time as shown in Examples 2-1 to 2-21. In the present invention, most of the adhesive layer can be released in a short time. Thus, even when a small amount of the adhesive layer remains after the releasing, the adhesive residue is dissolved by dissolved components in the releasing and dissolving composition, and is cleanly removed. This is also shown by the results of Examples 2-1 to 2-21. As shown in Examples 2-1 to 2-21, the adhesive layer on the semiconductor substrate could be cleanly eliminated only by immersing the semiconductor substrate in the releasing and dissolving composition of the present invention for a short time of 3 minutes.

Hence, the use of the method for cleaning a semiconductor substrate of the present invention makes it is possible to more cleanly remove (clean) the adhesive layer from the semiconductor substrate having the adhesive layer on the surface thereof in a shorter time by a simple operation.

**[Table 1]**

| | Composition | | | | | | | | | Release time (seconds) | Residue after releasing |
|---|---|---|---|---|---|---|---|---|---|---|---|
| | Component II: N-substituted amide compound (%) | | | | Component III: cyclic hydrocarbon (%) | | Component IV (%) | | TBAF (phr to total amount of solvent) | | |
| | N-methyl-2-pyrrolidone | N-ethyl-2-pyrrolidone | N,N-dimethylpropionamide | 1,3-dimethyl-2-imidazolidinone | p- menthane | Limonene | Dipropylene glycol dimethyl ether | Butyl acetate | | | |
| Example 2-1 | 20 | | | | 20 | | 60 | | 3 | 22 | Absent |
| Example 2-2 | 30 | | | | 20 | | 50 | | | 27 | Absent |
| Example 2-3 | 30 | | | | 30 | | 40 | | | 18 | Absent |
| Example 2-4 | 30 | | | | 40 | | 30 | | | 14 | Absent |
| Example 2-5 | 40 | | | | 20 | | 20 | | | 35 | Absent |
| Example 2-6 | 40 | | | | 30 | | 30 | | | 20 | Absent |
| Example 2-7 | 40 | | | | 40 | | 20 | | | 15 | Absent |
| Example 2-8 | 50 | | | | 20 | | 30 | | | 33 | Absent |
| Example 2-9 | 50 | | | | 30 | | 20 | | | 20 | Absent |
| Example 2-10 | 60 | | | | 20 | | 20 | | | 47 | Absent |

**[Table 2]**

| | Composition | | | | | | | | | Release time (seconds) | Residue after releasing |
|---|---|---|---|---|---|---|---|---|---|---|---|
| | Component II: N-substituted amide compound (%) | | | | Component III: cyclic hydrocarbon (%) | | Component IV (%) | | TBAF (phr to total amount of solvent) | | |
| | N-methyl-2-pyrrolidone | N-ethyl-2-pyrrolidone | N,N-dimethylpropionamide | 1,3-dimethyl-2-imidazolidinone | p- menthane | Limonene | Dipropylene glycol dimethyl ether | Butyl acetate | | | |
| Example 2-11 | | 30 | | | 20 | | 50 | | 3 | 31 | Absent |
| Example 2-12 | | 40 | | | 30 | | 30 | | | 21 | Absent |
| Example 2-13 | | 60 | | | 20 | | 20 | | | 150 | Absent |
| Example 2-14 | | | 30 | | 20 | | 50 | | | 26 | Absent |
| Example 2-15 | | | 40 | | 30 | | 30 | | | 19 | Absent |
| Example 2-16 | | | | 30 | 20 | | 50 | | | 29 | Absent |
| Example 2-17 | | | | 40 | 30 | | 30 | | | 19 | Absent |
| Example 2-18 | | | | 60 | 20 | | 20 | | | 43 | Absent |
| Example 2-19 | 40 | | | | | 30 | 30 | | | 95 | Absent |
| Example 2-20 | 20 | | | | 40 | | | 40 | | 10 | Absent |
| Example 2-21 | | | 40 | | 30 | | | 30 | | 15 | Absent |

**[Table 3]**

| | Composition | | | | | | | | Release time (seconds) | Residue after releasing |
|---|---|---|---|---|---|---|---|---|---|---|
| | Component II: N-substituted amide compound (%) | | | | Component III: cyclic hydrocarbon (%) | | Component IV (%) | TBAF (phr to total amount of solvent) | | |
| | N-methyl-2-pyrrolidone | N-ethyl-2-pyrrolidone | N,N-dimethylpropionamide | 1,3-dimethyl-2-imidazolidinone | p- menthane | Limonene | Dipropylene glycol dimethyl ether | | | |
| Comparative Example 1-1 | 30 | | | | 10 | | 60 | 3 | 300 < | N.A. |
| Comparative Example 1-2 | 40 | | | | 50 | | 10 | | N.A. | N.A. |
| Comparative Example 1-3 | 60 | | | | 10 | | 30 | | 300 < | N.A. |
| Comparative Example 1-4 | 60 | | | | 30 | | 10 | | N.A. | N.A. |
| Comparative Example 1-5 | 60 | | | | 40 | | 0 | | N.A. | N.A. |
| Comparative Example 1-6 | 80 | | | | 20 | | 0 | | N.A. | N.A. |
| Comparative Example 1-7 | 30 | | | | 20 | | 50 | 0 | 33 | Present |
| Comparative Example 1-8 | 30 | | | | 40 | | 30 | | 15 | Present |
| Comparative Example 1-9 | 40 | | | | 40 | | 20 | | 15 | Present |
| Comparative Example 1-10 | 60 | | | | 20 | | 20 | | 54 | Present |

## Claims

1. A method for cleaning a semiconductor substrate, the method comprising a step of releasing and dissolving an adhesive layer formed on a semiconductor substrate using a releasing and dissolving composition,
wherein the releasing and dissolving composition contains:
a component [I]: a quaternary ammonium salt;
a component [II]: an amide-based solvent;
a component [III]: a solvent represented by any one of the following Formulae (L0) to (L4); and
a component [IV]: a solvent represented by Formula (T) or (G) below: 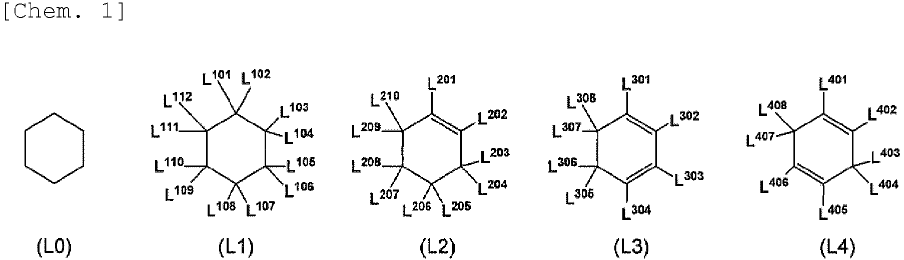
where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, and at least one of L³⁰¹ to L³⁰¹ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 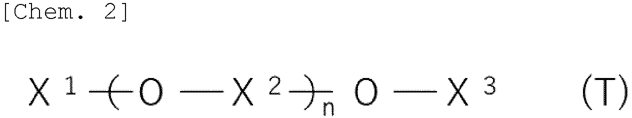
where X¹ and X³ each independently represent an alkyl group or an acyl group (X⁴-C(=O)-), X² represents an alkylene group, n represents 2 or 3, and X⁴ represents an alkyl group 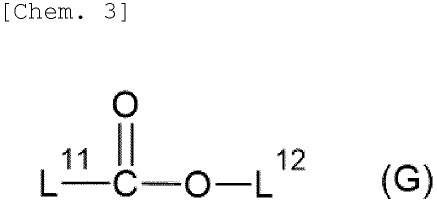
where L¹¹ and L¹² each independently represent an alkyl group having 1 to 6 carbon atoms, and a total number of carbon atoms of the alkyl group in L¹¹ and the alkyl group in L¹² is 7 or less.

2. The method for cleaning a semiconductor substrate according to claim 1, wherein the quaternary ammonium salt is a halogen-containing quaternary ammonium salt.

3. The method for cleaning a semiconductor substrate according to claim 1, wherein the amide-based solvent is an acid amide derivative represented by the following Formula (Z) or a compound represented by the following Formula (Y): 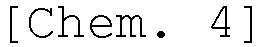 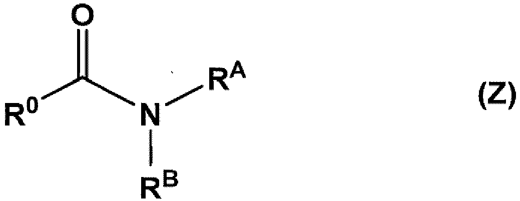 where R⁰ represents an ethyl group, a propyl group, or an isopropyl group, and R^{A} and R^{B} each independently represent an alkyl group having 1 to 4 carbon atoms 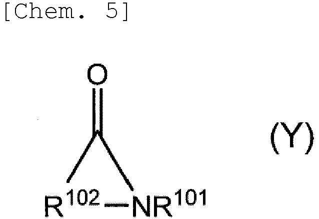 where R¹⁰¹ represents a hydrogen atom or an alkyl group having 1 to 6 carbon atoms, and R¹⁰² represents an alkylene group having 1 to 6 carbon atoms or a group represented by the following Formula (Y1) 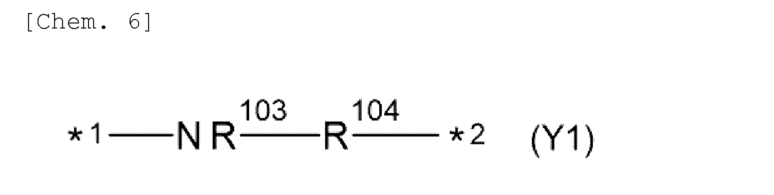 where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).

4. The method for cleaning a semiconductor substrate according to claim 1, wherein the alkyl group having 1 to 5 carbon atoms is a methyl group, an ethyl group, an n-propyl group, or an isopropyl group,
the alkenyl group having 2 to 5 carbon atoms is an ethenyl group, a 1-methylethenyl group, or a **2-**methylethenyl group, and
the alkynyl group having 2 to 5 carbon atoms is an ethynyl group or a 2-methylethynyl group.

5. The method for cleaning a semiconductor substrate according to claim 4, wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.

6. The method for cleaning a semiconductor substrate according to claim 1, wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

7. The method for cleaning a semiconductor substrate according to claim 6, wherein the adhesive component (S) contains a siloxane-based adhesive.

8. The method for cleaning a semiconductor substrate according to claim 7, wherein the siloxane-based adhesive includes a polyorganosiloxane component (A') which is cured by a hydrosilylation reaction.

9. The method for cleaning a semiconductor substrate according to claim 1, wherein the step of releasing and dissolving an adhesive layer includes a step of eliminating the released adhesive layer.

10. A method for producing a processed semiconductor substrate, the method comprising:
a first step of producing a laminate including a semiconductor substrate, a support substrate, and an adhesive layer formed from an adhesive composition;
a second step of processing the semiconductor substrate of the produced laminate;
a third step of separating the semiconductor substrate and the adhesive layer from the support substrate; and
a fourth step of releasing and dissolving the adhesive layer using a releasing and dissolving composition to remove the adhesive layer on the semiconductor substrate;
wherein the releasing and dissolving composition contains:
a component [I]: a quaternary ammonium salt;
a component [II]: an amide-based solvent;
a component [III]: a solvent represented by any one of the following Formulae (L0) to (L4); and
a component [IV]: a solvent represented by Formula (T) or (G) below: 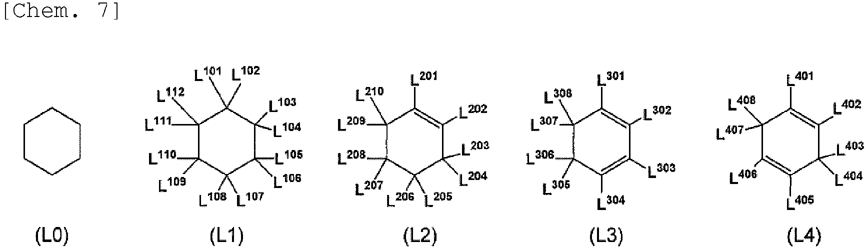
where L¹⁹¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 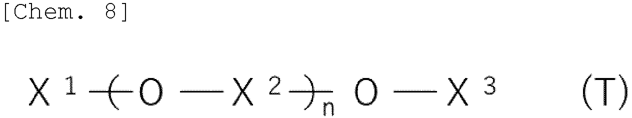
where X¹ and X³ each independently represent an alkyl group or an acyl group (X⁴-C(=O)-), X² represents an alkylene group, n represents 2 or 3, and X⁴ represents an alkyl group 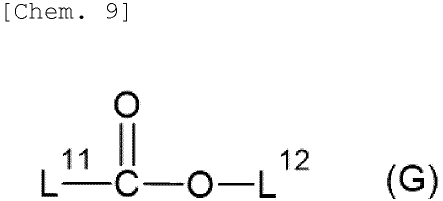
where L¹¹ and L¹² each independently represent an alkyl group having 1 to 6 carbon atoms, and a total number of carbon atoms of the alkyl group in L¹¹ and the alkyl group in L¹² is 7 or less.

11. The method for producing a processed semiconductor substrate according to claim 10, wherein the quaternary ammonium salt is a halogen-containing quaternary ammonium salt.

12. The method for producing a processed semiconductor substrate according to claim 10, wherein the amide-based solvent is an acid amide derivative represented by the following Formula (Z) or a compound represented by the following Formula (Y): 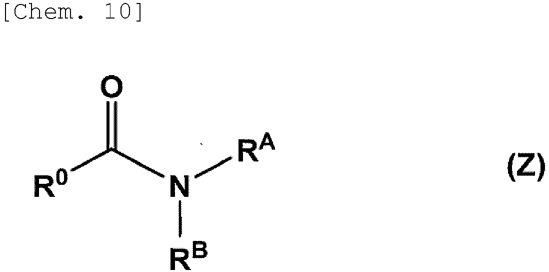 where R⁰ represents an ethyl group, a propyl group, or an isopropyl group, and R^{A} and R^{B} each independently represent an alkyl group having 1 to 4 carbon atoms 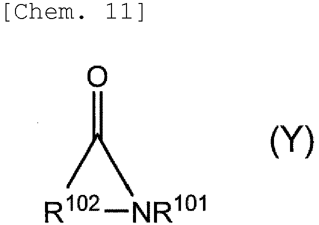 where R¹⁰¹ represents a hydrogen atom or an alkyl group having 1 to 6 carbon atoms, and R¹⁰² represents an alkylene group having 1 to 6 carbon atoms or a group represented by the following Formula (Y1) 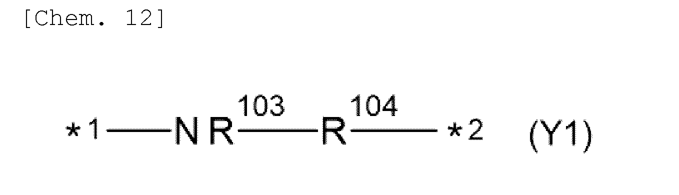 where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).

13. The method for producing a semiconductor substrate according to claim 10, wherein the alkyl group having 1 to 5 carbon atoms is a methyl group, an ethyl group, an n-propyl group, or an isopropyl group,
the alkenyl group having 2 to 5 carbon atoms is an ethenyl group, a 1-methylethenyl group, or a 2-methylethenyl group, and
the alkynyl group having 2 to 5 carbon atoms is an ethynyl group or a 2-methylethynyl group.

14. The method for producing a semiconductor substrate according to claim 13, wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.

15. The method for producing a processed semiconductor substrate according to claim 10, wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

16. The method for producing a processed semiconductor substrate according to claim 15, wherein the adhesive component (S) contains a siloxane-based adhesive.

17. The method for producing a processed semiconductor substrate according to claim 16, wherein the siloxane-based adhesive contains a polyorganosiloxane component (A') which is cured by a hydrosilylation reaction.

18. The method for producing a processed semiconductor substrate according to claim 10, wherein the fourth step of releasing and dissolving the adhesive layer to remove the adhesive layer includes a step of eliminating the released adhesive layer.

19. A releasing and dissolving composition used for releasing and dissolving an adhesive layer on a semiconductor substrate when the semiconductor substrate is cleaned to remove the adhesive layer, the releasing and dissolving composition comprising:
a component [I]: a quaternary ammonium salt;
a component [II]: an amide-based solvent;
a component [III]: a solvent represented by any one of the following Formulae (L0) to (L4); and
a component [IV]: a solvent represented by Formula (T) or (G) below;
wherein in the releasing and dissolving composition, a content of the component [III] is 20 mass% or more and a content of the component [IV] is 20 mass% or more, relative to 100 mass% of an aprotic solvent: 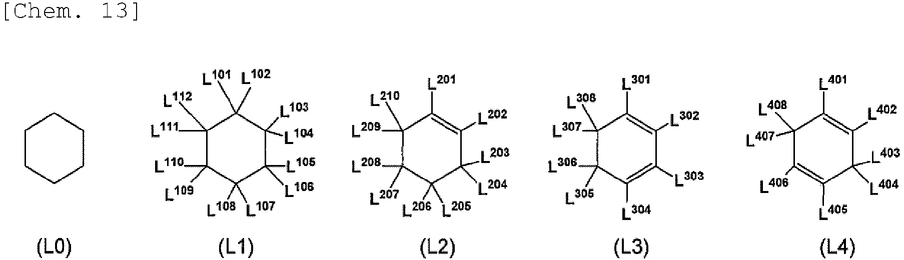
where L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, at least one of L¹⁰¹ to L¹¹² represents an alkyl group having 1 to 5 carbon atoms, an alkenyl group having 2 to 5 carbon atoms, or an alkynyl group having 2 to 5 carbon atoms, L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, at least one of L²⁰¹ to L²¹⁰ represents an alkyl group having 1 to 5 carbon atoms, an alkenyl group having 2 to 5 carbon atoms, or an alkynyl group having 2 to 5 carbon atoms, and L³⁰¹ to L³⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L³⁰¹ to L³⁰⁸ represents an alkyl group having 1 to 5 carbon atoms, an alkenyl group having 2 to 5 carbon atoms, or an alkynyl group having 2 to 5 carbon atoms, and L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, and at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms 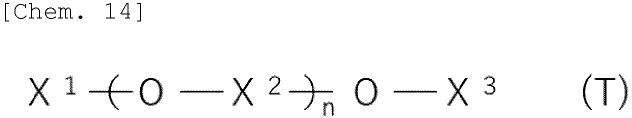
where X¹ and X³ each independently represent an alkyl group or an acyl group (X⁴-C(=O)-), X² represents an alkylene group, n represents 2 or 3, and X⁴ represents an alkyl group 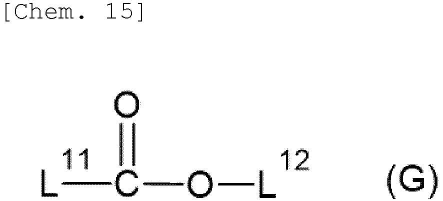
where L¹¹ and L¹² each independently represent an alkyl group having 1 to 6 carbon atoms, and a total number of carbon atoms of the alkyl group in L¹¹ and the alkyl group in L¹² is 7 or less.

20. The releasing and dissolving composition according to claim 19, wherein the quaternary ammonium salt is a halogen-containing quaternary ammonium salt.

21. The releasing and dissolving composition according to claim 19, wherein the amide-based solvent is an acid amide derivative represented by the following Formula (Z) or a compound represented by the following Formula (Y): 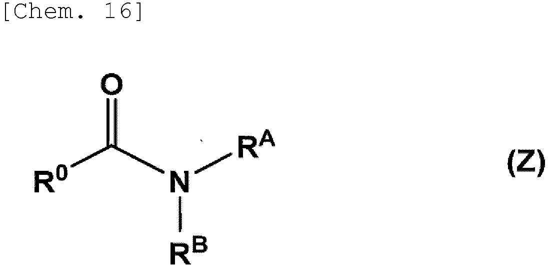 where R⁰ represents an ethyl group, a propyl group, or an isopropyl group, and R^{A} and R^{B} each independently represent an alkyl group having 1 to 4 carbon atoms 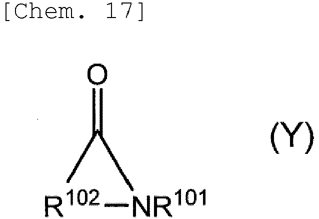 where R¹⁰¹ represents a hydrogen atom or an alkyl group having 1 to 6 carbon atoms, and R¹⁰² represents an alkylene group having 1 to 6 carbon atoms or a group represented by the following Formula (Y1) 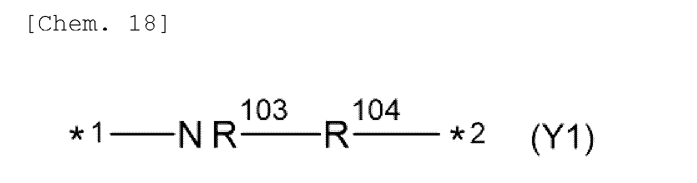 where R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in Formula (Y), and *2 represents a bonding hand bonded to a nitrogen atom in Formula (Y).

22. The releasing and dissolving composition according to claim 19, wherein the alkyl group having 1 to 5 carbon atoms is a methyl group, an ethyl group, an n-propyl group, or an isopropyl group,
the alkenyl group having 2 to 5 carbon atoms is an ethenyl group, a 1-methylethenyl group, or a 2-methylethenyl group, and
the alkynyl group having 2 to 5 carbon atoms is an ethynyl group or a 2-methylethynyl group.

23. The releasing and dissolving composition according to claim 22, wherein one or two of L¹⁰¹ to L¹¹² are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L²⁰¹ to L²¹⁰ are an alkyl group having 1 to 5 carbon atoms, an alkenyl group having 2 to 5 carbon atoms, or an alkynyl group having 2 to 5 carbon atoms, and the remaining Ls are hydrogen atoms;
one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; and
one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms.

24. The releasing and dissolving composition according to claim 19, wherein the adhesive layer is a film formed using an adhesive composition which contains an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

25. The processed releasing and dissolving composition according to claim 24, wherein the adhesive component (S) contains a siloxane-based adhesive.

26. The releasing and dissolving composition according to claim 25, wherein the siloxane-based adhesive contains a polyorganosiloxane component (A') which is cured by a hydrosilylation reaction.
